# EUROPEAN PATENT APPLICATION

(11) **EP 4 712 114 A1**
(43) Date of publication of application: **18.03.2026**
(21) Application number: 25195486.3
(22) Date of filing: 12.08.2025
(51) Int. Cl.: H01F 17/00

(54) **METHODS AND APPARATUS FOR POWER DELIVERY THROUGH PACKAGE SUBSTRATES WITH STACKS OF GLASS LAYERS HAVING DIFFERENT COEFFICIENTS OF THERMAL EXPANSION**

(30) Priority: 12.09.2024 US 202418883796
(71) Applicant: INTEL Corporation, Santa Clara, CA 95054 (US)
(72) Inventor: PIETAMBARAM, Srinivas Venkata Ramanuja, Chandler, AZ 95249 (US); DUAN, Gang, Chandler, AZ 85248 (US); LIU, Minglu, Chandler, AZ 85248 (US)
(74) Representative: HGF

(57) **Abstract**

Systems, apparatus, articles of manufacture, and methods for power delivery through package substrates with stacks of glass layers having different coefficients of thermal expansion are disclosed. An example substrate for an integrated circuit package includes: a first glass layer having a first coefficient of thermal expansion (CTE); a second glass layer having a second CTE, the second CTE different from the first CTE; a conductive material extending through a first hole in the first glass layer and a second hole in the second glass layer; and a magnetic material between an inner wall of the first hole and the conductive material.

## Description

### BACKGROUND

Integrated circuit (IC) chips and/or semiconductor dies are routinely connected to larger circuit boards such as motherboards and other types of printed circuit boards (PCBs) via a package substrate. As IC chips and/or dies reduce in size and interconnect densities increase, alternatives to traditional substrate layers are being developed to provide stable transmission of high frequency data signals between different circuitry and/or increased power delivery. One option being pursued is the implementation of package substrates with glass cores. Generally, glass core implementations offer several advantages compared to implementations with conventional epoxy cores, including a higher plated through-hole (PTH) density, lower signal losses, and lower total thickness variation.

### BRIEF DESCRIPTION OF THE DRAWINGS

FIG. 1 illustrates an example integrated circuit (IC) package constructed in accordance with teachings disclosed herein.
FIG. 2A illustrates an example substrate core that may be used to implement the example substrate core of FIG. 1.
FIG. 2B illustrates another example substrate core that may be used to implement the example substrate core of FIG. 1.
FIGS. 3-18 illustrate different stages in an example fabrication process to manufacture the example substrate core of FIG. 2A.
FIGS. 19 and 20 illustrate different stages in another example fabrication process to manufacture the example substrate core of FIG. 2A.
FIGS. 21-26 illustrate different stages in an example fabrication process to manufacture the example substrate core of FIG. 2B.
FIG. 27A illustrates another example substrate core that may be used to implement the example substrate core of FIG. 1.
FIG. 27B illustrates another example substrate core that may be used to implement the example substrate core of FIG. 1.
FIG. 28 illustrates another example substrate core that may be used to implement the example substrate core of FIG. 1.
FIGS. 29-42 illustrate different stages in an example fabrication process to manufacture the example substrate core of FIG. 28.
FIG. 43 illustrates another example substrate core that may be used to implement the example substrate core of FIG. 1.
FIGS. 44-49 illustrate different stages in an example fabrication process to manufacture the example substrate core of FIG. 43.
FIGS. 50-52 are flowcharts representative of example methods that may be performed to fabricate any one of the example package substrate cores of FIGS. 1-49.
FIG. 53 is a top view of a wafer including dies that may be included in an IC package constructed in accordance with teachings disclosed herein.
FIG. 54 is a cross-sectional side view of an IC device that may be included in an IC package constructed in accordance with teachings disclosed herein.
FIG. 55 is a cross-sectional side view of an IC device assembly that may include an IC package constructed in accordance with teachings disclosed herein.
FIG. 56 is a block diagram of an example electrical device that may include an IC package constructed in accordance with teachings disclosed herein.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

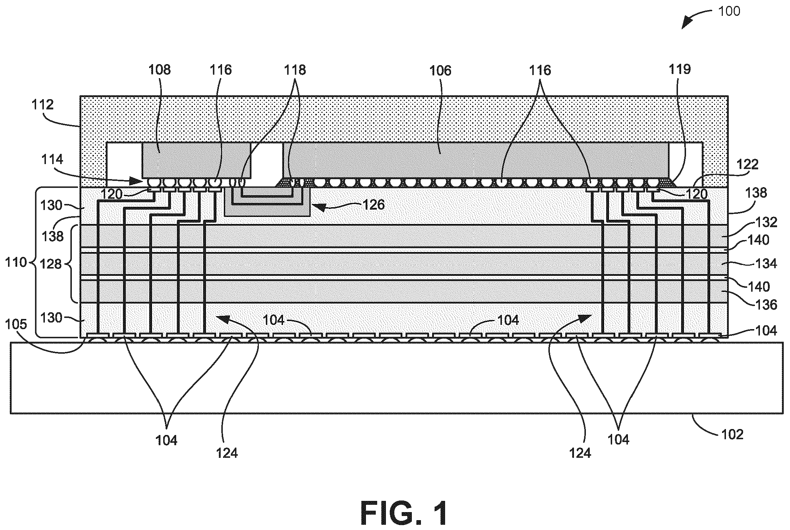

FIG. 1 illustrates an example integrated circuit (IC) package 100 constructed in accordance with teachings disclosed herein. In the illustrated example, the IC package 100 is electrically coupled to a circuit board 102 via an array of contact pads or lands 104 on a mounting surface 105 (e.g., a bottom surface) of the package. In some examples, the IC package 100 may include balls, pins, and/or pads, in addition to or instead of the contact pads 104, to enable the electrical coupling of the package 100 to the circuit board 102. In this example, the package 100 includes two semiconductor (e.g., silicon) dies 106, 108 (sometimes also referred to as chips or chiplets) that are mounted to a package substrate 110 and enclosed by a package lid or mold compound 112. Thus, the package substrate 110 is an example means for supporting a semiconductor die. While the example IC package 100 of FIG. 1 includes two dies 106, 108, in other examples, the package 100 may have only one die or more than two dies. In some examples, one of the dies 106, 108 (or a separate die) is embedded in the package substrate 110. The dies 106, 108 can provide any suitable type of functionality (e.g., data processing, memory storage, etc.).

As shown in the illustrated example, each of the dies 106, 108 is electrically and mechanically coupled to the substrate 110 via corresponding arrays of interconnects 114. In FIG. 1, the interconnects are shown as bumps. However, the interconnects 114 may be any other type of electrical connection in addition to or instead of the bumps shown (e.g., balls, pins, pads, wire bonding, etc.). The electrical connections between the dies 106, 108 and the substrate 110 (e.g., the interconnects 114) are sometimes referred to as first level interconnects. By contrast, the electrical connections between the IC package 100 and the circuit board 102 (e.g., the pads 104) are sometimes referred to as second level interconnects. In some examples, one or both of the dies 106, 108 may be stacked on top of one or more other dies and/or an interposer. In such examples, the dies 106, 108 are coupled to the underlying die and/or interposer through a first set of first level interconnects and the underlying die and/or interposer may be connected to the package substrate 110 via a separate set of first level interconnects associated with the underlying die and/or interposer. Thus, as used herein, first level interconnects refer to interconnects (e.g., balls, bumps, pins, pads, wire bonding, etc.) between a die and a package substrate or a die and an underlying die and/or interposer.

As shown in FIG. 1, the interconnects 114 of the first level interconnects include two different types of bumps corresponding to core bumps 116 and bridge bumps 118. As used herein, the core bumps 116 are bumps on the dies 106, 108 through which electrical signals pass between the dies 106, 108 and components external to the IC package 100. More particularly, as shown in the illustrated example, when the dies 106, 108 are mounted to the package substrate 110, the core bumps 116 are physically connected and electrically coupled to contact pads 120 on an inner surface 122 of the substrate 110. The contact pads 120 on the inner surface 122 of the package substrate 110 are electrically coupled to the landing pads 104 on the bottom (external) surface 105 of the substrate 110 (e.g., a surface opposite the inner surface 122) via internal interconnects 124 within the substrate 110. As a result, there is a continuous electrical signal path between the core bumps 116 of the dies 106, 108 and the landing pads 104 mounted to the circuit board 102 that pass through the contact pads 120 and the interconnects 124 provided therebetween.

As used herein, the bridge bumps 118 are bumps on the dies 106, 108 through which electrical signals pass between different ones of the dies 106, 108 within the package 100. Thus, as shown in the illustrated example, the bridge bumps 118 of the first die 106 are electrically coupled to the bridge bumps 118 of the second die 108 via a silicon-based interconnect die 126 (e.g., interconnect bridge) embedded in the package substrate 110. As represented in FIG. 1, core bumps 116 are typically larger than bridge bumps 118. In some examples, the interconnect bridge 126 and the associated bridge bumps 118 are omitted.

In some examples, an underfill material 119 is disposed between the dies 106, 108 and the package substrate 110 around and/or between the first level interconnects 114 (e.g., around and/or between the core bumps 116 and/or the bridge bumps 118). In the illustrated example, only the first die 106 is associated with the underfill material 119. However, in other examples, both dies 106, 108 are associated with the underfill material 119. In other examples, the underfill material 119 is omitted. In some examples, the mold compound 112 is used as an underfill material that surrounds the first level interconnects 114.

In some examples, the IC package 100 includes additional passive components, such as surface-mount resistors, capacitors, and/or inductors disposed on the bottom (external) surface 105 of the package substrate 110 and/or the top (inner) surface 122 of the package substrate 110.

In FIG. 1, the substrate 110 of the example IC package 100 includes a substrate core 128 (e.g., a main core, an overall core) between two separate build-up regions 130 (e.g., build-up layers, redistribution layers). As shown in the illustrated example, the substrate core 128 includes multiple distinct glass cores 132, 134, 136 (e.g., sub-cores, glass substrates, glass layers, glass sheets) stacked on top of one another. In some examples, the cores 132, 134, 136 include at least one of: aluminosilicate, borosilicate, alumino-borosilicate, silica, and/or fused silica. In some examples, the cores 132, 134, 136 include one or more additives including: aluminum oxide (Al₂O₃), boron trioxide (B₂O₃), magnesia oxide (MgO), calcium oxide (CaO), stoichiometric silicon oxide (SrO), barium oxide (BaO), stannic oxide (SnO₂), nickel alloy (Na₂O), potassium oxide (K₂O), phosphorus trioxide (P₂O₃), zirconium dioxide (ZrO₂), lithium oxide (Li₂O), titanium (Ti), and/or zinc (Zn). In some examples, the cores 132, 134, 136 include silicon and oxygen. In some examples, the cores 132, 134, 136 include silicon, oxygen and/or one or more of aluminum, boron, magnesium, calcium, barium, tin, sodium, potassium, strontium, phosphorus, zirconium, lithium, titanium, and/or zinc. In some examples, the cores 132, 134, 136 include at least 23 percent silicon by weight and at least 26 percent oxygen by weight. In some examples, the glass cores 132, 134, 136 are individual layers of glass including silicon, oxygen, and aluminum. In some examples, the cores 132, 134, 136 include at least 23 percent silicon by weight, at least 26 percent oxygen by weight, and at least 5 percent aluminum by weight. In some examples, as discussed further below, different ones of the glass cores 132, 134, 136 include different materials or different compositions of materials so that the different glass cores 132, 134, 136 are associated with different coefficients of thermal expansion (CTE). In some examples, the CTE is modified between the different glass cores 132, 134, 136 by changing the amount of alkali dopants (e.g., Na₂O, K₂O, etc.) included in the glass. In general, the lower the alkali content, the lower the CTE. Thus, for a CTE of 3 ppm/°C, the alkali content may be less than 0.1%. By contrast, for a CTE of 9 ppm/°C, the alkali content can be up to 20%.

In some examples, the cores 132, 134, 136 are amorphous solid glass layers. In some examples, the cores 132, 134, 136 are layers of glass that do not include an organic adhesive or an organic material. In some examples, the cores 132, 134, 136 are solid layers of glass having a rectangular shape in plan view. In some examples, the cores 132, 134, 136, as glass substrates, include at least one glass layer and do not include epoxy and do not include glass fibers (e.g., do not include an epoxy-based prepreg layer with glass cloth). In some examples, the cores 132, 134, 136 correspond to single pieces of glass that extend the full height/thickness of each corresponding core.

In some examples, the cores 132, 134, 136 have a rectangular shape that is substantially coextensive, in plan view, with the layers above and/or below the core. In some examples, the cores 132, 134, 136 have a thickness in a range of about 25 micrometers (µm) to about 400 µm (with the thickness of the overall substrate core 128 ranging from about 50 µm to about 1.4 millimeters (mm). In some examples, the cores 132, 134, 136 can have dimensions of about 10 mm on a side to about 250 mm on a side (e.g., 10 mm by 10 mm to 250 mm by 250 mm). In some examples, the cores 132, 134, 136 correspond to rectangular prism volumes with sections (e.g., vias) removed and filled with other materials (e.g., metal).

The build-up regions 130 are represented in FIG. 1 as masses/blocks with the internal interconnects 124 extending in straight lines through the build-up regions 130 (and the glass cores 132, 134, 136). However, FIG. 1 has been simplified for the sake of clarity and purposes of explanation. In practice, the interconnects are not necessarily straight. More particularly, in some examples, the build-up regions 130 are defined by alternating layers of dielectric material and layers of conductive material (e.g., a metal such as copper). The conductive (metal) layers serve as the basis for the internal interconnects 124 represented, in a simplified form, by straight lines as shown in FIG. 1. In some examples, the metal layers are patterned to define electrical routing or conductive traces that are electrically coupled between different metal layers by conductive (e.g., metal) vias extending through intervening dielectric layers. Further, the electrical routing or traces on either side of the substrate core 128 may be electrically coupled by through-glass vias (TGVs) (e.g., copper plated vias) extending through the glass cores 132, 134, 136.

Among other things, glass cores are advantageous over epoxy-based cores because glass is stiffer and, therefore, provides for greater mechanical support or strength for the package substrate. Thus, the substrate core 128 and, more particularly, the individual glass cores 132, 134, 136 are example means for strengthening the package substrate. In addition to mechanical benefits, glass cores also provide other advantages including a higher plated through-hole (PTH) density, lower signal losses, and a lower total thickness variation. However, glass cores also present challenges due to the fragile (e.g., brittle) nature of glass and the possibility of defects that can develop into cracks that propagate through the glass.

A common type of failure of known glass cores is referred to as a seware failure. Seware failures result in the separation of a glass core along a crack that propagates from an edge of the glass core along its length and width between the main outer surfaces (e.g., upper and lower surfaces, front and back surfaces) of the glass core. That is, seware failures are characterized by a glass core being split into two separate sheets of glass along a line extending generally parallel to the main plane of the glass core.

Factors that contribute to seware failures include defects on the edges of glass cores resulting from singulation and the internal stress induced by a mismatch in coefficient of thermal expansion (CTE) between the glass core (e.g., a CTE of around 3 ppm/°C to 10 ppm/°C) and the material in the build-up regions (e.g., a CTE of around 39 ppm/°C for the organic dielectric layers, a CTE of around 17 ppm/°C for the copper, and a CTE around 2.6 ppm/°C for silicon) during thermal cycles of the package substrate 110. More particularly, package substrates, such as the package substrate 110 of FIG. 1, are often fabricated on a large panel that is subsequently singulated or cut into individual units with a saw. Thus, in the illustrated example of FIG. 1, the package substrate 110, including the substrate core 128 (and the associated sub-cores 132, 134, 136) and the build-up regions 130, include opposing edges 138 that are created by the cut of a saw. Such sawing can result in defects developing on the edges of glass cores (e.g., the edges 138 of the glass cores 132, 134, 136 in FIG. 1) that can give rise to cracks that propagate laterally across the middle of the glass core to split the glass core into two or more pieces. The development and propagation of cracks in this manner is exacerbated by stress induced by fluctuations in temperature and the difference in CTE of the build-up regions relative to the CTE of the glass core. Generally, the material in the build-up regions 130 have a higher CTE than glass. As a result, the material in the build-up regions 130 expand and contract more than a glass core in response to thermal fluctuations, thereby causing internal stress within the glass core that can promote crack propagation.

Examples disclosed herein reduce (minimize) concerns for seware failures by implementing the core 128 of the substrate with multiple distinct (e.g., disaggregated) glass cores 132, 134, 136 stacked on top of one another as shown in FIG. 1. More particularly, in examples disclosed herein, the different stacked cores 132, 134, 136 are implemented by different materials (or different compositions of the same materials) associated with different CTEs. In some examples, the glass cores that are closer to the build-up regions 130 are fabricated with a CTE that is closer to the CTE of the build-up regions 130 than the CTE of the glass cores farther away from the build-up regions 130 (e.g., closer to the middle of the stack of glass cores). In this manner, the substrate core 128 is defined by a gradation of CTEs or incremental changes in CTE (between each stacked glass core 132, 134, 136) that provide a transition between the different layers in the package substrate 110 to reduce stress at any given location. Thus, in some examples, the middle glass core 134 has a lower CTE than the top glass core 132 and a lower CTE than the bottom glass core 136. In some examples, the CTE of the top glass core 132 and the bottom glass core 136 are the same. Thus, in some examples, the different CTEs of the glass cores 132, 134, 136 are symmetrical across the overall thickness of the substrate core 128. That is, the arrangement or ordering of the stack of glass cores 132, 134, 136 and their associated CTEs define a symmetric sequence of CTEs from a lowermost glass core (e.g., the third glass core 136) to an uppermost glass core (e.g., the first glass core 132). In other examples, the different CTEs may not be symmetrical. For instance, in some examples, the top glass core 132 (e.g., the glass core closest to the dies 106, 108) has the highest CTE (e.g., around 7 ppm/°C to 9 ppm/°C) in the stack and the bottom glass core 136 (e.g., the glass core farthest from the dies 106, 108) has the lowest CTE (e.g., around 3 ppm/°C to 5 ppm/°C) with the central glass core 134 having a CTE between the other two (e.g., around 5 ppm/°C to 7 ppm/°C). In other examples, the top glass core 132 (e.g., the glass core closest to the dies 106, 108) has the lowest CTE in the stack with the bottom glass core 136 having the highest CTE in the stack. In some examples, when there are more than three glass cores, the CTE for each core is more precisely tuned that in the above example to provide an incremental change in CTE value between each successive glass core in the stack corresponding to any suitable CTE gradient. That is, any suitable arrangement of differing CTE values across any suitable number of stacked glass cores may additional or alternatively be implemented to achieve any suitable CTE gradient across the overall substrate core 128.

In addition to implementing multiple glass cores with different CTEs to reduce stress, in some examples, a buffer material 140 (e.g., adhesive material) is disposed between adjacent ones of the glass cores 132, 134, 136 to hold the glass cores together. In some such examples, the buffer material 140 has a relatively low modulus of elasticity to absorb stress resulting from thermal fluctuations and the different CTEs of the different glass cores 132, 134, 136, thereby further reducing stress internal to the substrate core 128. In some examples, the buffer material is an organic dielectric material (e.g., polyimide, parylene, etc.). In some examples, the buffer material is an inorganic dielectric material (e.g., silicon oxide (SiOₓ), silicon nitride (SiNₓ)). In some examples, the buffer material includes a carbon doped oxide (CDO). In some examples, one or more of the layers of the buffer material 140 may be omitted such that different ones of the glass cores 132, 134, 136 are directly abutting. In some examples, the layers of the buffer material 140 include conductive material that facilitates the redistribution of electrical paths between the glass cores 132, 134, 136. Thus, the materials between the glass cores are also referred to herein as redistribution material that defines one or more redistribution layers in the package substrate 100.

Although three different glass cores 132, 134, 136 are shown in the example substrate core 128 of FIG. 1, any other suitable number of glass cores may be implemented with corresponding CTEs to define a particular CTE gradient across the overall thickness of the substrate core 128. Thus, in some examples, only two glass cores, each with a different CTE, are employed. In other examples, more than three glass cores are employed. In some such examples, each glass core is different than every other glass core in the stack of cores. In other examples, two or more of the glass cores may have the same CTE (e.g., made from the same materials with the same composition) with at least one glass core having a different CTE than the others.

In the illustrated example of FIG. 1, each of the glass cores 132, 134, 136 is shown as having the same thickness. However, in some examples, the thickness of the glass cores 132, 134, 136 may differ from one another. For instance, in some examples, the middle glass core 134 is thicker than the top glass core 132 and thicker than the bottom glass core 136. In other examples, the middle glass core 134 is thinner than the top glass core 132 and thinner than the bottom glass core 136. Any suitable thickness for the glass cores can be implemented to achieve a suitable CTE gradient that reduces stress to mitigate against to seware failures while also providing sufficient rigidity for the package substrate.

While the stacking of multiple glass cores 132, 134, 136 with different CTEs as disclosed herein can serve to reduce stress that may otherwise lead to seware failures, the stack of glass cores 132, 134, 136 also presents challenges in the fabrication of the portion of the interconnects 124 that extend through the glass cores 132, 134, 136. Examples disclosed herein overcome some of these challenges. More particularly, the following description and associated figures disclose example structures and associated fabrication processes to implement electrical lines for power delivery (e.g., coaxial magnetic inductor loops (CMILs) and plated magnetic vias (PMVs)) through the stack of glass cores 132, 134, 136. As used herein, CMILs and PMVs are different types of power delivery interconnects.

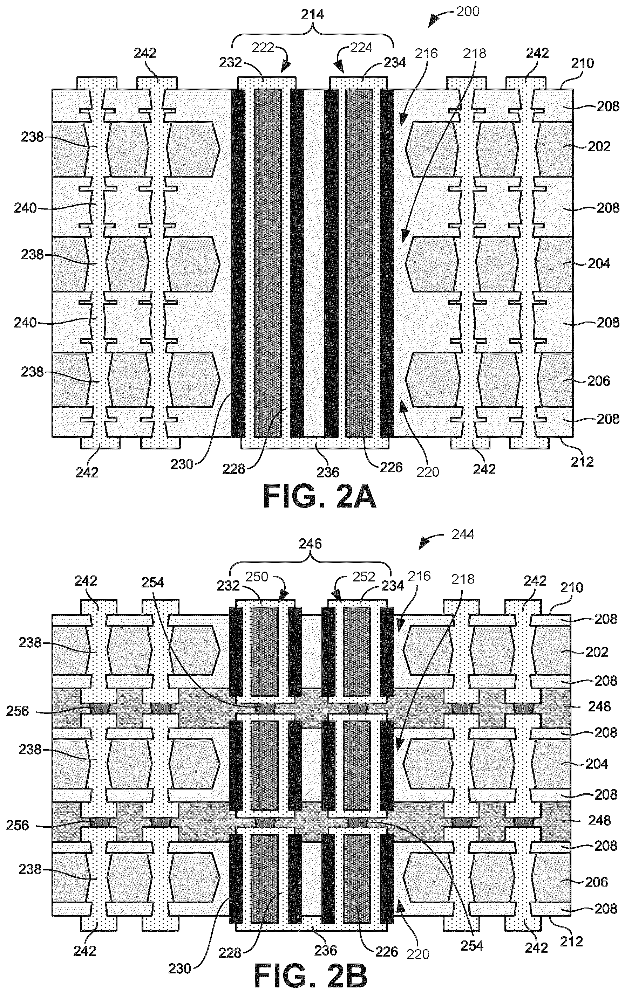

FIG. 2A illustrates an example substrate core 200 that may be used to implement the example substrate core 128 of FIG. 1. Similar to FIG. 1, the substrate core 200 of FIG. 2A includes a first glass core 202, a second glass core 204, and a third glass core 206 that are stacked on top of one another. In this example, the different glass cores 202, 204, 206 correspond to the glass cores 132, 134, 136 of FIG. 1. Thus, the glass cores 202, 204, 206 include different CTEs as described above. For instance, in some examples, the second glass core 204 (e.g., the middle glass core) has a lower CTE than either the first glass core 202 or the third glass core 206. In this example, each of the glass cores 202, 204, 206 have approximately the same thickness. In some examples, the thickness is approximately 350 micrometers (µm). In other examples, the thickness can be greater or less than 350 µm. Further, in some examples, different ones of the glass cores 202, 204, 206 can have different thicknesses. Additionally, while three glass cores are shown, in some examples, any other suitable number of glass cores (e.g., 2, 4, 5, 6, 7, etc.) may be employed. In such examples, the stack of glass cores can define any suitable CTE gradient based on differences in the CTE for each glass core in the stack. In some examples, the CTE gradient is symmetrical across the overall thickness of the substrate core 200. In other examples, the CTE gradient may not be symmetrical.

In the illustrated example, the different glass cores 202, 204, 206 are separated by intervening layers of dielectric material 208 (e.g., buffer material, adhesive material). In some examples, the dielectric material 208 includes an organic epoxy-based dielectric. However, any other suitable dielectric may additionally or alternatively be used. In this example, in addition to being between the glass cores 202, 204, 206, the dielectric material 208 is on the outermost surfaces of the outermost glass cores (e.g., the first and third glass cores 202, 206). Thus, in this example, the dielectric material 208 defines first and second outer surfaces 210, 212 of the overall substrate core 200. However, in some examples, the outermost layers of the dielectric material 208 shown in FIG. 2A may be omitted and/or correspond to a first layer of build-up regions (e.g., the build-up regions 130 of FIG. 1) on either side of the substrate core 200. In such examples, the outer surfaces of the first and third glass cores 202, 206 define the first and second outer surfaces 210, 212 of the overall substrate core 200.

In the illustrated example of FIG. 2A, a CMIL 214 (e.g., power delivery interconnect) extends through the substrate core 200 between the first and second outer surfaces 210, 212. The CMIL 214 serves to enhance power delivery through a package substrate (e.g., the package substrate 110 of FIG. 1) containing the substrate core 200. As shown in FIG. 2A, the CMIL 214 extends continuously through a first opening 216 (e.g., first cavity) in the first glass core 202, a second opening 218 (e.g., second cavity) in the second glass core 204, and a third opening 220 (e.g., third cavity) in the third glass core 206. In this example, the dielectric material 208 also extends through the openings 216, 218, 220 in the different glass cores 202, 204, 206. The CMIL 214 is defined by two plated through holes that extend through the dielectric material 208 (and through the openings 216, 218, 220 in the glass cores 202, 204, 206) includes first and second portions 222, 224 that extend through adjacent through holes in the dielectric material 208. In this example, each of the first and second portions 222, 224 of the CMIL 214 includes a non-magnetic plug 226 (e.g., non-magnetic core) defining a central region of each portion 222, 224 that is surrounded by a conductive material 228 that is itself surrounded by a magnetic material 230 (e.g., magnetic lining). In some examples, the non-magnetic plug 226 includes a dielectric material (e.g., epoxy). In some examples, the conductive material 228 includes copper. In other examples, any other suitable conductive material may be used. In some examples, the magnetic material 230 can be any suitable material with magnetic properties (e.g., iron, alloys containing iron (e.g., silicon steel), a ferrite material (e.g., nickel zinc ferrite (e.g., NiₐZn₍₁₋ₐ₎Fe2O₄), a manganese ferrite (e.g., MnₐZn₍₁₋ₐ₎Fe₂O₄), a cobalt ferrite (e.g., CoFe₂O₄, CoO·Fe₂O₃), etc.), other ferromagnetic particles or elements, etc.).

In the illustrated example of FIG. 2A, the first and second portions of the CMIL 214 are capped on the first outer surface 210 of the substrate core 200 with respective first and second conductive pads 232, 234. In this example, the conductive pads 232, 234 include the same material as the conductive material 228 (e.g., copper) that extends along the axial lengths of the two portions of the CMIL 214. Further, as shown in FIG. 2A, the first and second portions of the CMIL 214 are electrically coupled along the second outer surface 212 of the substrate core 200 by a conductive pad 236 (e.g., a trace, a wire).

In addition to the CMIL 214 extending through the large openings 216, 218, 220 in the glass cores 202, 204, 206, the glass cores 202, 204, 206 also include through glass vias (TGVs) 238 that are electrically coupled by additional conductive material 240 extending through the intervening layers of the dielectric material 208. In some examples, the TGVs 238 are plated with the same material as used in the additional conductive material 240 (e.g., copper). In some examples, at least some of the additional conductive material 240 may contain a different material than the TGVs 238. Further, as shown in the illustrated example, conductive pads 242 are positioned on the outer surfaces 210, 212 of the substrate core 200 and electrically coupled to the TGVs 238 and the additional conductive material 240. In this example, the conductive pads 242 define opposite ends of interconnects (e.g., portions of the interconnects 124 of FIG. 1) extending the full thickness of the substrate core 200.

FIG. 2B illustrates another example substrate core 244 that may be used to implement the example substrate core 128 of FIG. 1. The example substrate core 244 of FIG. 2B is substantially the same as the example substrate core 200 of FIG. 2A except as noted below and/or otherwise made clear from the context. Accordingly, the features shown in FIG. 2B that are the same or similar to corresponding features in FIG. 2A are identified by the same reference numbers. Further, the description of such features described above in connection with FIG. 2A applies similarly with respect to the corresponding features in FIG. 2B. Specifically, the example substrate core 244 includes the first, second, and third glass cores 202, 204, 206 that include TGVs 238 extending therethrough. The glass cores 202, 204, 206 are separated by intervening layers of the dielectric material 208 deposited on both opposing surfaces of each of the glass cores 202, 204, 206. Thus, the outermost layers of the dielectric material 208 define the first and second outer surfaces 210, 212 of the substrate core 244. Further, the dielectric material 208 extends through corresponding openings 216, 218, 220 through the glass cores 202, 204, 206. The openings 216, 218, 220 provide space for an example CMIL 246 to extend through the substrate core 244.

FIG. 2B differs from FIG. 2A in the way the different glass cores 202, 204, 206 are stacked together, which results in differences in how the different segments of the CMIL 246 are coupled together. Specifically, in this example, an adhesive dielectric 248 is positioned between adjacent portions of the dielectric material 208 on facing surfaces of adjacent glass cores 202, 204, 206. In this example, the adhesive dielectric 248 (e.g., buffer material) is a different material than the dielectric material 208. More particularly, in some examples, the adhesive dielectric 248 is implemented by a material with a lower modulus of elasticity than the dielectric material 208 to provide more stress reduction between the glass cores 202, 204, 206 than in the example substrate core 200 of FIG. 2A that omit the adhesive dielectric 248. In other examples, the adhesive dielectric 248 can be the same material as the dielectric material 208.

In the illustrated example of FIG. 2B, the adhesive dielectric 248 is also disposed between adjacent ends of different segments of the CMIL 246. Thus, unlike what is shown in FIG. 2A, the non-magnetic plug 226, the conductive material 228, and the magnetic material 230 in the separate first and second portions 250, 252 of the CMIL 246 do not extend continuously along a full length of the CMIL 246. Rather, as shown in FIG. 2B, the non-magnetic plug 226, the conductive material 228, and the magnetic material 230 are divided into discrete segments that are spaced apart from one another. However, in this example, the different segments of the conductive material 228 are still electrically coupled together by conductive vias 254 extending through the adhesive dielectric 248. Further, similar conductive vias 256 extend through the adhesive dielectric 248 to electrically couple the TGVs 238 extending through the glass cores 202, 204, 206. In some examples, the conductive vias 254, 256 include the same material (e.g., plated copper) as the conductive material 228 in the CMIL 246 and the TGVs 238. In other examples, the conductive vias 254, 256 include a different conductive material (e.g., a sintered copper paste, a liquid metal (e.g., a gallium-based alloy) etc.).

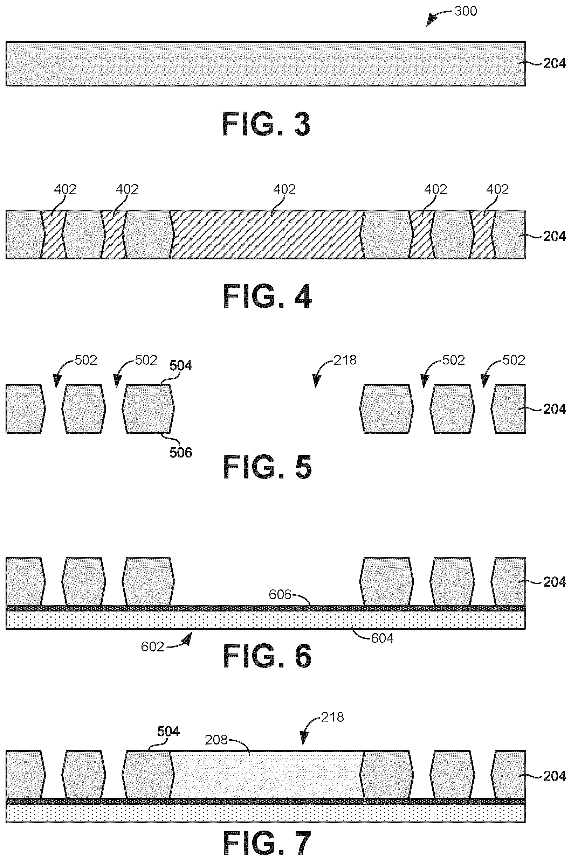

FIGS. 3-18 illustrate different stages in an example fabrication process to manufacture the example substrate core 200 of FIG. 2A. FIG. 3 represents a glass panel 300 corresponding to the initial state of any one of the glass cores 202, 204, 206. For purposes of explanation, the glass panel 300 is shown and described as corresponding to the second glass core 204 (e.g., the middle glass core in the substrate core 200 of FIG. 2A). In some examples, the glass panel 300 is fabricated to a thickness corresponding to the final thickness of the glass core 204. However, in some examples, the glass panel 300 is initially slightly larger than the final thickness of the glass core 204 to enable some amount of the glass to be removed during subsequent polishing or planarization processes as discussed further below.

FIG. 4 represents the stage of fabrication following exposure of the glass core 204 to a laser as part of a laser induced deep etching (LIDE) process. The laser is concentrated on defined regions 402 of the glass core 204 to modify the optical and chemical properties of the glass core 204 at those regions 402. FIG. 5 represents the stage of fabrication following a chemical etch process to remove the material in the modified regions 402 of the glass core 204 shown in FIG. 3 to define the large second opening 218 shown in FIG. 2A and additional openings 502 (e.g., vias) for the TGVs 238 shown in FIG. 2A. In this example, the openings 218, 502 have a cross-sectional profile generally corresponding to an hourglass shape with the width (e.g., diameter) of the openings 218, 502 being narrower near a midpoint of the openings between opposing first and second surfaces 504, 506 of the glass core 204. In other examples, one or more of the openings 218, 502 may have a different cross-sectional shape. For instance, in some examples, one or more of the openings 218, 502 may have a generally conical or tapered shape with the width (e.g., diameter) being smallest at one of the two surfaces 504, 506 of the glass core 204 and the width (e.g., diameter) being largest at the opposite surface 504, 506. In other examples, the width (e.g., diameter) of one or more of the openings 218, 502 is approximately consistent along a full length of the openings 218, 502 between the opposing surfaces 506, 508 of the glass core 204.

FIG. 6 represents the stage of fabrication following the glass core 204 being attached to a conductive carrier 602. In this example, the conductive carrier includes a conductive layer 604 (e.g., a copper layer) and a release layer 606 (e.g., an adhesive dielectric layer). FIG. 7 represents the stage of fabrication after the opening 218 in the glass core 204 is filled with the dielectric material 208. In some examples, the dielectric material 208 is dispensed as a liquid or paste into the opening and subsequently cured. In some examples, any excess of the dielectric material 208 that extends beyond the first surface 504 of the glass core 204 is removed by a polishing (e.g., a chemical mechanical planarization (CMP)) process. In some examples, this polishing process slightly thins the glass core 204.

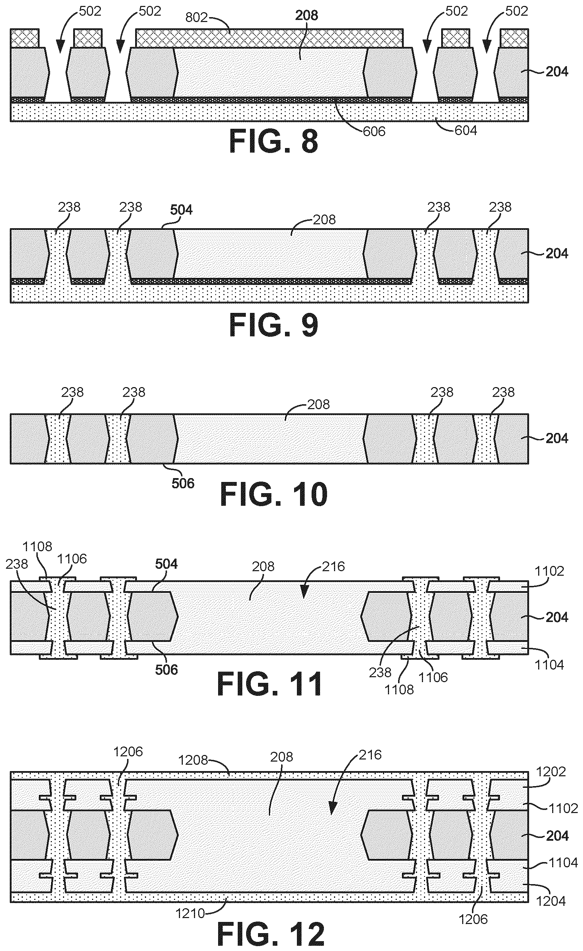

FIG. 8 represents the stage of fabrication following the application of a mask 802 (e.g., via photolithography) to cover the assembly except for the openings 502 of the glass core. Further, the stage of fabrication represented in FIG. 8 is after an etching process (e.g., a plasma etch, a dry etch) to remove portions of the release layer 606 exposed within the openings 502 of the glass core 204, thereby exposing the underlying conductive layer 604. The mask 802 protects the dielectric material 208 during the etching process.

FIG. 9 represents the stage of fabrication following the removal (e.g., stripping) of the mask 802 and subsequent plating of copper within the openings 502 to define the TGVs 238 extending through the glass core 204. In this example, the TGVs 238 are plated up from the exposed portions of the conductive layer 604. As such, in this example, there is no seed layer deposited along the walls of the openings 502 prior to the plating process. However, in other examples, a seed layer may be used to facilitate the plating of the TGVs 238. In some examples, a liner of a low modulus material (e.g., silicon oxide (SiOₓ), carbon doped oxide (CDO), polyimide, parylene, etc.) can be added on the surface of the glass prior to depositing the metal for the TGVs 238 (including any seed layer, if included) to reduce stress. In some examples, the liner extends the full length of the TGVs 238. In other examples, the liner extends along limited portions (e.g., high stress areas) of the TGVs 238 (e.g., near the ends of the TGVs 238). In some examples, the liner is added prior to adding the dielectric material 208 in the second opening 218 such that the liner is between the dielectric material 208 and the glass core 204. In other examples, the liner is omitted. The stage of fabrication represented in FIG. 9 is also after a subsequent polishing process (e.g., a CMP process) to remove excess copper that extends above the first surface 504 of the glass core 204. Thus, in some examples, the both the dielectric material 208 and the TGVs 238 are flush with the first surface 504.

FIG. 10 represents the stage of fabrication following the removal of the conductive carrier 602, including both the conductive layer 604 and the release layer 606. In some examples, the second surface 506 of the glass core undergoes a polishing process (e.g., a CMP process) to make the both the dielectric material 208 and the TGVs 238 flush with the second surface 506. In some examples, the assembly also undergoes a cleaning process to remove any residue materials.

FIG. 11 represents the stage of fabrication following the application of first and second buffer layers 1102, 1104 (e.g., adhesive layers, dielectric layers) on the respective first and second surfaces 504, 506 of the glass core 204. In some examples, the buffer layers 1102, 1104 are applied through a lamination process. In some examples, the buffer layers 1102, 1104 are composed of the same material as the dielectric material 208 disposed within the large second opening 218 in the glass core 204. In other examples, the buffer layers 1102, 1104 are composed of a different material from the dielectric material 208 within the second opening 218. FIG. 11 also represents the result of adding conductive vias 1106 through the buffer layers 1102, 1104 to electrically couple the underlying TGVs 238 to associated conductive pads 1108. More particular, holes (e.g., vias) are drilled through the buffer layers 1102, 1104 to expose the ends of the TGVs 238 and then the holes are filled to define the material of the conductive vias 1106 and to produce the conductive pads 1108.

FIG. 12 represents the stage of fabrication following the application of additional dielectric layers 1202, 1204 on the respective first and second buffer layers 1102, 1104. In some examples, the additional dielectric layers 1202, 1204 are applied through a lamination process. In some examples, the additional dielectric layers 1202, 1204 are composed of the same material as the dielectric material 208 disposed within the large second opening 218 and/or the same material as the buffer layers 1102, 1104. In other examples, the additional dielectric layers 1202, 1204 are composed of a different material than the dielectric material 208 within the second opening 218and/or different than the material used for the buffer layers 1102, 1104. Further, in this example, additional conductive vias 1206 are provided through the additional dielectric layers 1202, 1204 and electrical coupled with conductive blankets 1208, 1210 on the outer surfaces of both sides of the assembly. In some examples, the conductive material added within and/or on the dielectric material 208 and/or the additional dielectric layers 1202, 1204 serves to redistribute signal paths. Thus, the dielectric material 208, the additional dielectric layers 1202, 1204, and the associated conductive material is sometimes referred to herein as redistribution material that defines one or more redistribution layers in the package substrate 200 of FIG. 2

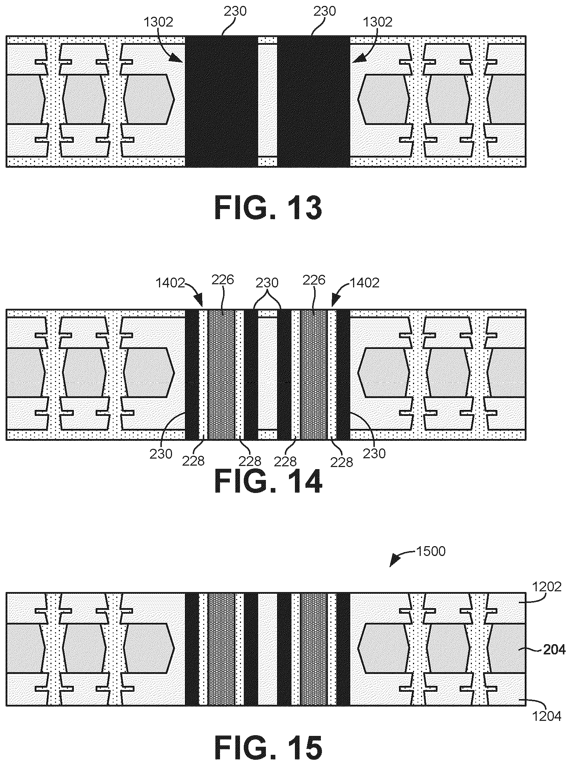

FIG. 13 represents the stage of fabrication following the drilling of holes 1302 through the dielectric material 208, the buffer layers 1102, 1104, and the additional dielectric layers 1202, 1204. Further, at the stage of fabrication represented in FIG. 13, the through holes 1302 are filled the magnetic material 230 used in the CMIL 214. In this example, the holes 1302 define the outer extent of the first and second portions 222, 224 of the CMIL 214 shown in FIG. 2A. In some examples, the magnetic material 230 is deposited within the holes 1302 as a paste or resin that is subsequently cured. Thereafter, a grinding and/or polishing process (e.g., a CMP process) may be employed on both sides of the assembly to remove excess material.

FIG. 14 represents the stage of fabrication following the drilling of inner through-holes 1402 through the middle of the different portions of the magnetic material 230. Further, at the stage of fabrication represented in FIG. 14, the walls of the inner through-holes 1402 (e.g., the inner walls of the magnetic material 230) are plated with the conductive material 228. In some examples, this is accomplished through a bottom-up plating process. In other examples, this is accomplished through direct plating onto the magnetic material 230 and/or a seed layer on the magnetic material 230.

As shown in FIG. 14, the remaining central region of the inner through-holes 1402 (inside of the conductive material 228) is filled the non-magnetic plug 226. In some examples, the non-magnetic plug 226 is deposited within the central region of the conductive material 228 as a paste or resin that is subsequently cured. Thereafter, a grinding and/or polishing process (e.g., a CMP process) may be employed on both sides of the assembly to remove excess material.

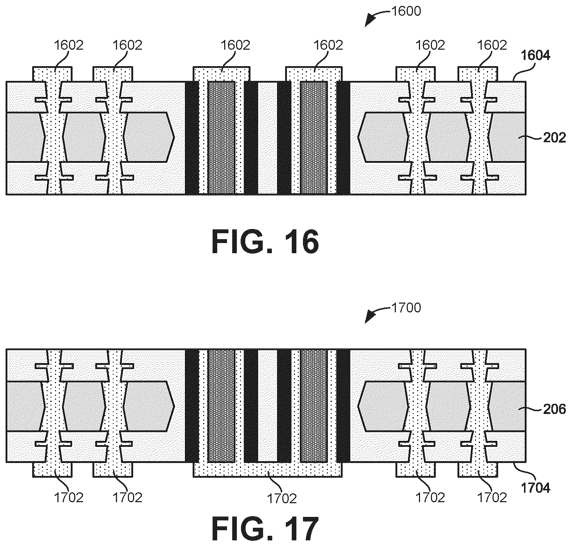

FIG. 15 represents the stage of fabrication following a grinding and/or polishing process (e.g., a CMP process) to make the ends of the constructed segment of the CMIL 214 flush with the additional dielectric layers 1202, 1204. In some examples, the stage of fabrication represented by FIG. 15 corresponds to a complete glass core assembly 1500 at the end of processing of the second glass core 204 prior to being stacked with the other glass cores 202, 206 (that have been processed to include other segments of the CMIL 214). In some examples, the first and third glass cores 202, 206 are processed in a similar manner to the second glass core 204 as outlined above. Thus, FIG. 16 represents a complete glass core assembly 1600 following completion of the processing of the first glass core 202, and FIG. 17 represents a complete glass core assembly 1700 following completion of the processing of the third glass core 206. As shown, the end result shown in FIG. 16 is substantially the same as the end result shown in FIG. 15, except that FIG. 16 follows the additional operations to provide conductive pads 1602 onto one of the outer surfaces 1604 (e.g., the upper surface) of the assembly. In this example, the outer surface 1604 corresponds to the first surface 210 of the substrate core 200 of FIG. 2A, and the conductive pads 1602 correspond to the conductive pads 232, 234, 242 along the first surface 210 of the substrate core 200 of FIG. 2A. Similarly, the end result shown in FIG. 17 is substantially the same as the end result shown in FIG. 15, except that FIG. 17 follows the additional operations to provide conductive pads 1702 onto one of the outer surfaces 1704 (e.g., the bottom surface) of the assembly. In this example, the outer surface 1704 corresponds to the second surface 212 of the substrate core 200 of FIG. 2A, and the conductive pads 1702 correspond to the conductive pads 236, 242 along the second surface 212 of the substrate core 200 of FIG. 2A.

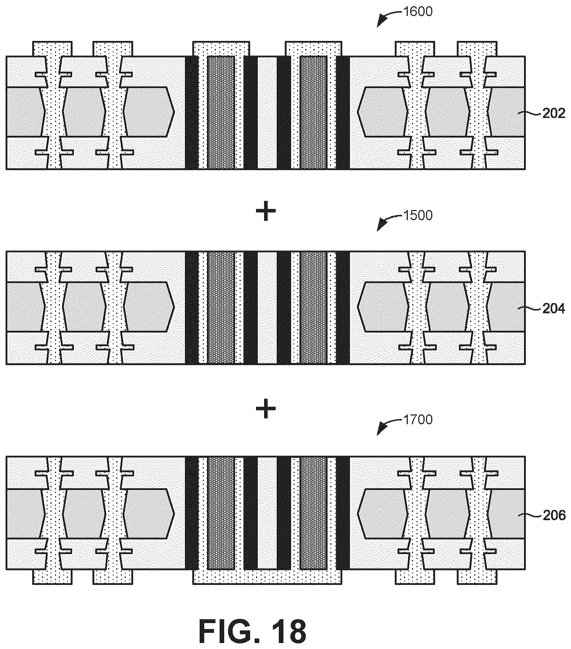

FIG. 18 represents the stage of fabrication when the three glass cores 202, 204, 206 are assembled or stacked together by combining or joining the associated glass core assemblies 1500, 1600, 1700 of FIGS. 15-17. In some examples, an adhesive resin is used on the interfacing surfaces of the different glass core assemblies 1500, 1600, 1700 to join them together. More particularly, in some examples, the adhesive is a dielectric adhesive that is applied to the regions of the dielectric material on the interfacing surfaces of the glass core assemblies 1500, 1600, 1700. In some such examples, a liquid metal or copper paste is deposited between portions of the interfacing surfaces defined by conductive material (e.g., the vias 1206 and the conductive material 228 of the CMIL 214) to electrically couple the conductive material in the stack. Additionally or alternatively, in some examples, additional conductive pads (similar to the conductive pads 1108 discussed in connection with FIG. 11) can be added at the interfacing surfaces of the glass core assemblies 1500, 1600, 1700 to facilitate the electrical coupling of the conductive material. Further, in some examples, additional non-magnetic plug 226 and magnetic material 230 can also be disposed at the corresponding locations to connect the associated portions of the CMIL 214. In other examples, no additional material is added between the interfacing surfaces of the glass core assemblies 1500, 1600, 1700. Instead, the material on the interfacing surfaces is directly joined (e.g., with fusion bonds). The result of combining or joining the different glass core assemblies 1500, 1600, 1700 produces the substrate core 200 shown in FIG. 2A.

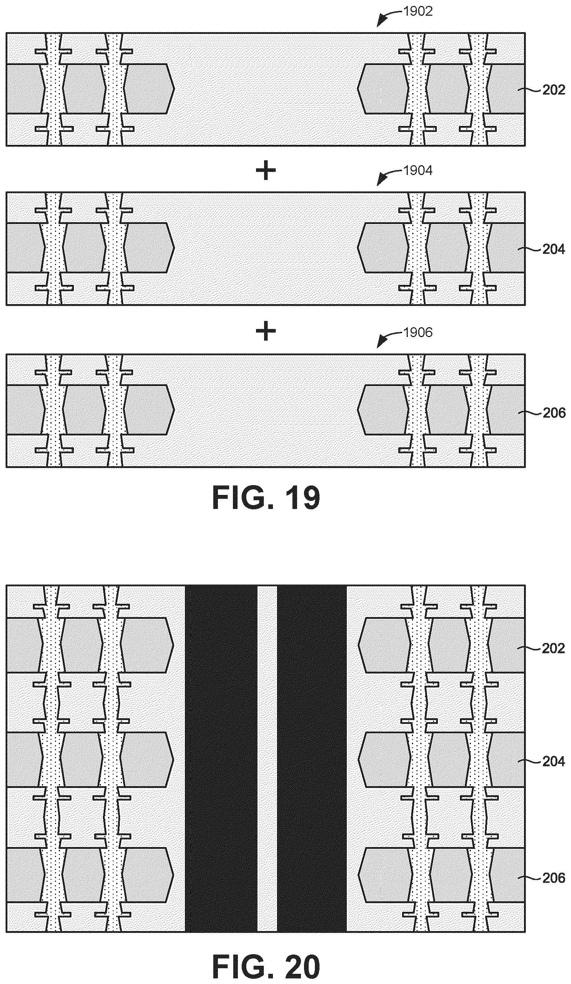

FIGS. 19 and 20 illustrate different stages in another example fabrication process to manufacture the example substrate core 200 of FIG. 2A. In this example, the components of the CMIL 214 are not added until after the glass cores 202, 204, 206 are already combined and stacked together. Specifically, FIG. 19 represents the stage of fabrication following the fabrication of three separate glass core assemblies 1902, 1904, 1906 as the assemblies are being combined or joined. In this example, the glass core assemblies 1902, 1904, 1906 are similar to the glass core assembly 1500 of FIG. 15, except that the glass core assemblies 1902, 1904, 1906 of FIG. 19 do not include the non-magnetic plug 226, do not include the conductive material 228 surrounding such non-magnetic plug 226, and do not include the magnetic material 230 surrounding such conductive material 228. That is, in some examples, the glass core assemblies 1902, 1904, 1906 of FIG. 19 are fabricated following the same process detailed above in connection with FIGS. 3-15 except that the processes detailed in connection with FIGS. 13 and 14 are omitted.

After the glass core assemblies 1902, 1904, 1906 are joined together, through-holes are drilled through the entire stack and subsequently filled with the magnetic material 230 as represented in FIG. 20 (and similar to what is discussed above in connection with FIG. 13). Thereafter, an inner through-hole can be drilled through the magnetic material 230 to make room for the conductive material 228 and the non-magnetic plug 226 following the process detailed above in connection with FIG. 14. Subsequently, conductive pads can be added to both sides of the stack to produce the final substrate core 200 shown in FIG. 2A.

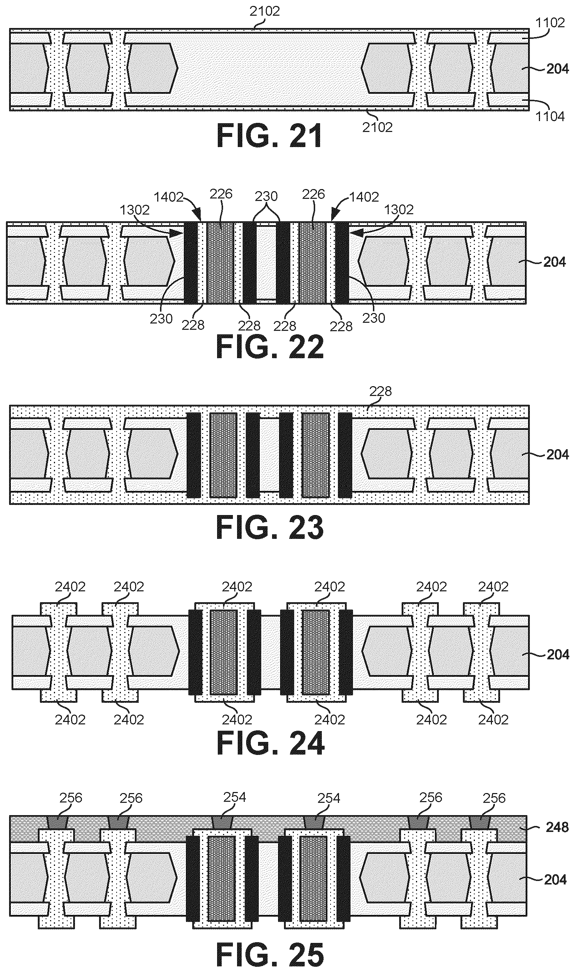

FIGS. 21-26 illustrate different stages in an example fabrication process to manufacture the example substrate core 244 of FIG. 2B. The process to fabricate the example substrate core 244 of FIG. 2B can follow the same or similar processes detailed above in connection with the different stages of fabrication represented by FIGS. 3-18 discussed above except as noted below and/or otherwise made clear from the context. More particularly, the process can be the same or identical up through the stage of fabrication represented in FIG. 10. FIG. 21 represents the stage of fabrication similar to what is shown in FIG. 11, except that in FIG. 21 complete layers of metal 2102 are retained on the outer surfaces of the buffer layers 1102, 1104. That is, unlike what is described in connection with FIG. 11, the conductive pads 1108 are not defined at the stage of fabrication represented in FIG. 21.

FIG. 22 represents the stage of fabrication similar to what is shown and described in connection with FIG. 13-14 above. That is, holes 1302 are drilled through the assembly and then filled with the magnetic material 230 similar to FIG. 13. Further, the conductive material 228 is plated on walls of inner through-holes 1402 within the magnetic material 230 and then the remaining central region of the inner through-holes 1402 are filled the non-magnetic plug 226. FIG. 22 differs from what is shown in FIG. 13 and 14 in that the additional dielectric layers 1202, 1204 (added in FIG. 12) are omitted.

FIG. 23 represents the stage of fabrication following the deposition (e.g., plating) of additional amounts of the conductive material 228 to extend across the end of the constructed segments of the CMIL 246. Thus, in this example, the non-magnetic plug 226 in each segment of the CMIL 246 is enclosed by the conductive material 228. Further, as shown in the illustrated example, the thickness of the layer of metal 2102 (added in FIG. 21) becomes thicker at the stage of fabrication represented in FIG. 23 because of the additional amounts of conductive material 228 added thereon.

FIG. 24 represents the stage of fabrication following the removal (e.g., via etching) of portions of the outer layers of metal to define conductive pads 2402 for the TGVs 238 and the constructed segments of the CMIL 246. The conductive pads 2402 are similar to the conductive pads 1602 discussed above in connection with FIG. 16. However, unlike what is shown in FIG. 16, in the illustrated example of FIG. 24, the conductive pads 2402 are added to both sides of the assembly (e.g., at both ends of the TGVs 238 and both ends of the segments of the CMIL 246).

FIG. 25 represents the stage of fabrication following the deposition (e.g., lamination) of the adhesive dielectric 248 and the subsequent drilling and filling of holes therein to provide the conductive vias 254, 256. FIG. 25 represents a complete glass core assembly following completion of the processing of the second glass core 204 to then be stacked or joined with the first and third glass cores 202, 206. In some examples, the first and third glass cores 202, 206 follow a similar process detailed in FIGS. 22-25 to produce corresponding glass core assemblies to be combined or joined together to define the stack of glass cores as shown in FIG. 2B.

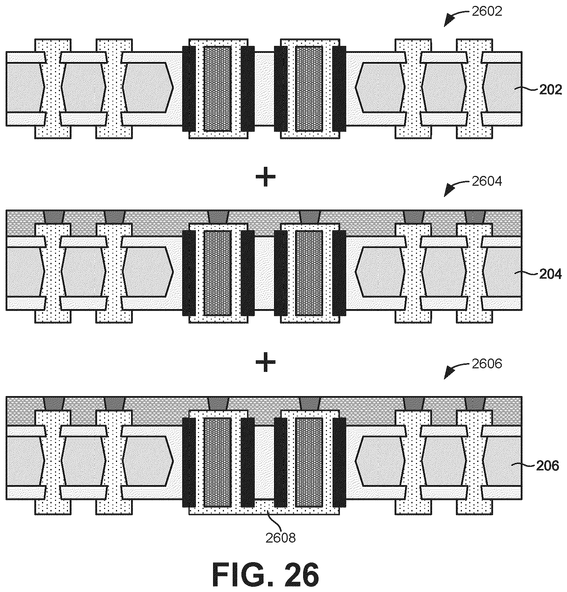

FIG. 26 represents the stage of fabrication when the three glass cores 202, 204, 206 are assembled or stacked together by combining or joining respective glass core assemblies 2602, 2604, 2606. In this example, each of the glass core assemblies 2602, 2604, 2606 of FIG. 11 are the result of processing the corresponding glass cores 202, 204, 206 through the stages of fabrication represented in FIGS. 3-10 and 22-25. That is, the second glass core 204 processed to the point represented in FIG. 25 corresponds to the second glass core assembly 2604 shown in FIG. 26. Further, as shown in FIG. 26, the third glass core assembly 2606 is substantially the same as the second glass core assembly 2604 except for a different glass core (e.g., the third glass core 206 instead of the second glass core 204) with a different CTE. A further difference between the second glass core assembly 2404 and the third glass core assembly 2406 is the inclusion of an example conductive pad 2608 that electrical coupled the corresponding segments of the CMIL 246. The example conductive pad 2608 is similar to the conductive pad 1702 discussed above in connection with FIG. 17. The first glass core assembly 2602 is similar to the other two glass core assemblies 2604, 2606 except for the different glass core 202 (with different CTE) and the absence of the adhesive dielectric 248 with the conductive vias 254 disposed therein. That is, in some examples, the first glass core assembly 2602 of FIG. 26 is completed by the stage of fabrication represented in FIG. 24 without proceeding with the operations discussed above in connection with FIG. 25. In some examples, once the different glass core assemblies 2602, 2604, 2606 are brought together (as represented in FIG. 26), the stack is pressed (e.g., subject to compression) and undergoes a curing process to join the assemblies. The final result of combining or joining the different glass core assemblies 2602, 2604, 2606 produces the substrate core 244 shown in FIG. 2B.

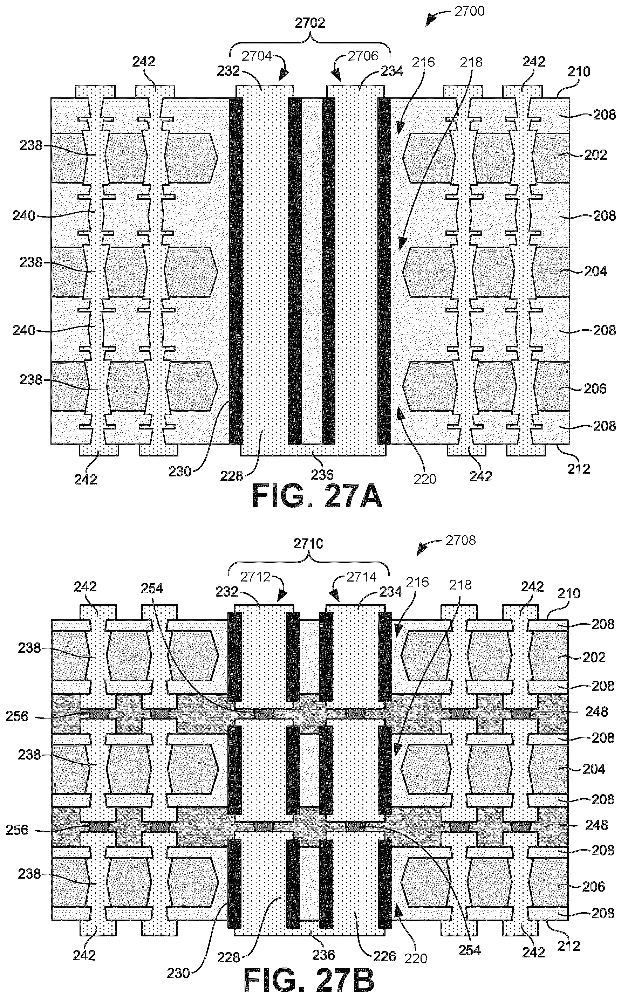

FIG. 27A illustrates another example substrate core 2700 that may be used to implement the example substrate core 128 of FIG. 1. The example substrate core 2700 of FIG. 27A is substantially the same as the example substrate core 200 of FIG. 2A except as noted below and/or otherwise made clear from the context. Accordingly, the features shown in FIG. 27A that are the same or similar to corresponding features in FIG. 2A (and associated FIGS. 3-18) are identified by the same reference numbers. Further, the description of such features described above in connection with FIG. 2A (and associated FIGS. 3-18) applies similarly with respect to the corresponding features in FIG. 27.

FIG. 27A differs from FIG. 2A in the construction of the example CMIL 2702 extending through the example substrate core 2700. Specifically, in FIG. 2A, the central regions of the two portions 222, 224 of the CMIL 214 are defined by the non-magnetic plug 226. By contrast, in the illustrated example of FIG. 27A, there is no non-magnetic plug in the first and second portions 2704, 2706 of the CMIL 2702. Instead, the central region of the two portions 2704, 2706 are defined by the conductive material 228 (e.g., copper) that fills the entire space inside of the magnetic material 230. That is, the conductive material 228 within the first and second portions 2704, 2706 is a solid mass that extends continuously from the inner surface of the magnetic material 230 to the center (e.g., central axis) of longitudinal lengths of the portions 2704, 2706. In other words, in the illustrated example of FIG. 27, each portion 2704, 2706 includes a solid metal core that extends continuously across a cross-section of the metal core.

The process to fabricate the example substrate core 2700 of FIG. 27A can follow the same or similar processes detailed above in connection with the different stages of fabrication represented by FIGS. 3-18 discussed above in connection with FIG. 2A, except that the non-magnetic plug 226 (discussed in connection with FIG. 14) is omitted. That is, rather than merely plating walls of the inner through-holes 1402 with the conductive material 228 to then fill the remaining central region with the non-magnetic plug 226, the entire area within the inner through-holes 1402 is filled with (e.g., via a plating process) the conductive material 228 to produce the substrate core 2700 of FIG. 27A. The subsequent fabrication processes discussed above in connection with FIGS. 15-18 can proceed in the same or similar manner as described above to produce different glass core assemblies that do not include non-magnetic plugs within the segments of the corresponding CMIL 2702. Once such glass core assemblies are combined (in line with the process discussed above in connection with FIG. 18 except for the absence of the non-magnetic plugs), the final result is the example substrate core 2700 of FIG. 27A.

FIG. 27B illustrates another example substrate core 2708 that may be used to implement the example substrate core 128 of FIG. 1. The example substrate core 2708 of FIG. 27B is substantially the same as the example substrate cores 244 of FIG. 2B except as noted below and/or otherwise made clear from the context. Accordingly, the features shown in FIG. 27B that are the same or similar to corresponding features in FIG. 2B (and associated FIGS. 3-18) are identified by the same reference numbers. Further, the description of such features described above in connection with FIGS. 2B (and associated FIGS. 3-18) applies similarly with respect to the corresponding features in FIG. 27B.

FIG. 27B differs from FIG. 2B in the construction of the example CMIL 2710 extending through the example substrate core 2708. Specifically, in FIG. 2B, the central regions of the two portions 250, 252 of the CMIL 214 are defined by the non-magnetic plug 226. By contrast, in the illustrated example of FIG. 27B, there is no non-magnetic plug in first and second portions 2712, 2714 of the CMIL 2710. Instead, the central region of the two portions 2712, 2714 are defined by the conductive material 228 (e.g., copper) that fills the entire space inside of the magnetic material 230. That is, the conductive material 228 within the first and second portions 2712, 2714 is a solid mass that extends continuously from the inner surface of the magnetic material 230 to the center (e.g., central axis) of longitudinal lengths of the portions 2712, 2714. In other words, in the illustrated example of FIG. 27B, each portion 2712, 2714 includes a solid metal core that extends continuously across a cross-section of the metal core.

The process to fabricate the example substrate core 2708 of FIG. 27B can follow the same or similar processes detailed above in connection with the different stages of fabrication represented by FIGS. 3-10 and 21-26 discussed above in connection with FIG. 2B, except that the non-magnetic plug 226 (discussed in connection with FIG. 22) is omitted. That is, rather than merely plating walls of the inner through-holes 1402 with the conductive material 228 to then fill the remaining central region with the non-magnetic plug 226, the entire area within the inner through-holes 1402 is filled with (e.g., via a plating process) the conductive material 228 to produce the substrate core 2708 of FIG. 27B. The subsequent fabrication processes discussed above in connection with FIGS. 23-26 can proceed in the same or similar manner as described above to produce different glass core assemblies that do not include non-magnetic plugs within the segments of the corresponding CMIL 2710. Once such glass core assemblies are combined (in line with the process discussed above in connection with FIG. 26 except for the absence of the non-magnetic plugs), the final result is the example substrate core 2708 of FIG. 27B.

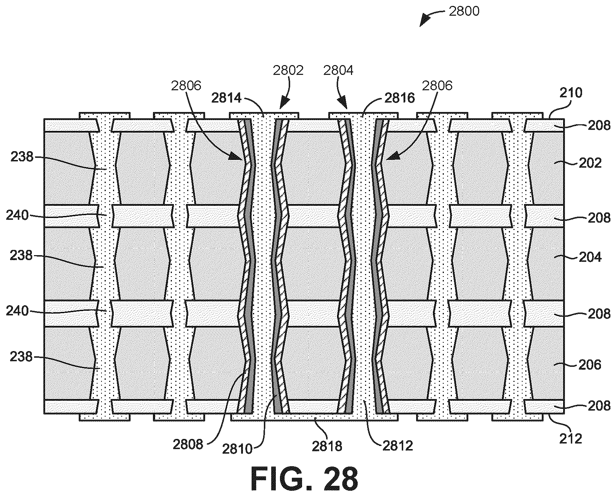

FIG. 28 illustrates another example substrate core 2800 that may be used to implement the example substrate core 128 of FIG. 1. Features shown in FIG. 28 that are the same or similar to corresponding features in FIGS. 2A, 2B, 27A, and 27B (and associated FIGS. 3-18 and 21-26) are identified by the same reference numbers. Further, the description of such features described above in connection with FIGS. 2A, 2B, 27A, and 27B (and associated FIGS. 3-18 and 21-26) applies similarly with respect to the corresponding features in FIG. 28. Specifically, the example substrate core 2800 includes the first, second, and third glass cores 202, 204, 206 that include TGVs 238 extending therethrough. The glass cores 202, 204, 205 are separated by intervening layers of the dielectric material 208 on both opposing surfaces of each of the glass cores 202, 204, 206. Thus, the outermost layers of the dielectric material 208 define the first and second outer surfaces 210, 212 of the substrate core 2800. Similar to what is shown in FIG. 2A, the TGVs 238 in the glass cores 202, 204, 206 are electrically coupled by additional conductive material 240 extending through the intervening layers of the dielectric material 208.

Unlike the foregoing examples that include CMILs 214, 246, 2702, 2710, the example substrate core 2800 of FIG. 28 includes a set of plated magnetic vias (PMVs) 2802, 2804 (e.g., power delivery interconnects) that extend through the full thickness of the substrate core 2800. The PMVs 2802, 2804 can serve a similar function to the CMILs 214, 246, 2702, 2710 of enhancing power delivery through a package substrate (e.g., the package substrate 110 of FIG. 1) containing the substrate core 2800. As shown in FIG. 28, the PMVs 2802, 2804 include a seed layer 2808 that lines a sidewall of openings 2806 (e.g., vias) extending through the respective glass cores 202, 204, 206. In this example, the seed layer 2808 can include ruthenium, titanium, copper, and/or any combination thereof. In some examples, the PMVs 2802, 2804 include a magnetic material 2810 that lines the inner wall of the seed layer 2808 (e.g., the seed layer surrounds the magnetic material 2810). In some examples, the magnetic material 2810 in FIG. 28 is made of Ni, Fe, or Co alloys that exhibit high magnetic permeabilities (e.g., above 20) are electroplated. That is, in some examples, the magnetic material 2810 in FIG. 28 is the same as or similar to the magnetic material 230 discussed above in connection with FIG. 2A. Additionally, the PMVs 2802, 2804 include a central region that is filled with a conductive material 2812. In some examples, the conductive material 2812 in FIG. 28 is the same as or similar to the conductive material 228 discussed above in connection with FIG. 2A (e.g., copper).

In the illustrated example of FIG. 28, the PMVs 2802, 2804 are capped on the first outer surface 210 of the substrate core 2800 with respective first and second conductive pads 2814, 2816. In this example, the conductive pads 2814, 2816 include the same material as the conductive material 2812 (e.g., copper) that extends along the axial lengths of the PMVs 2802, 2804. Further, as shown in FIG. 2A, 2B, the PMVs 2802, 2804 are electrically coupled along the second outer surface 212 of the substrate core 2800 by a conductive pad 2818 (e.g., a trace, a wire).

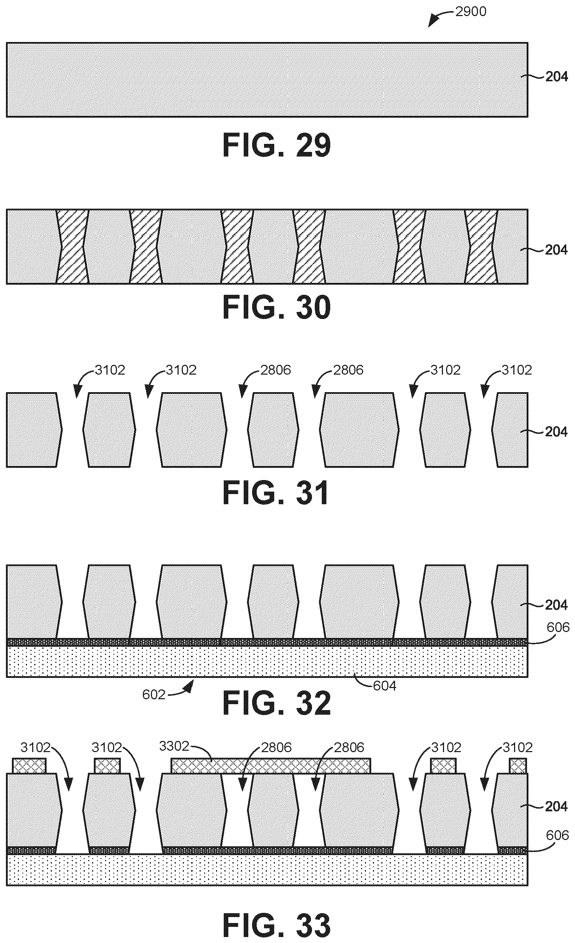

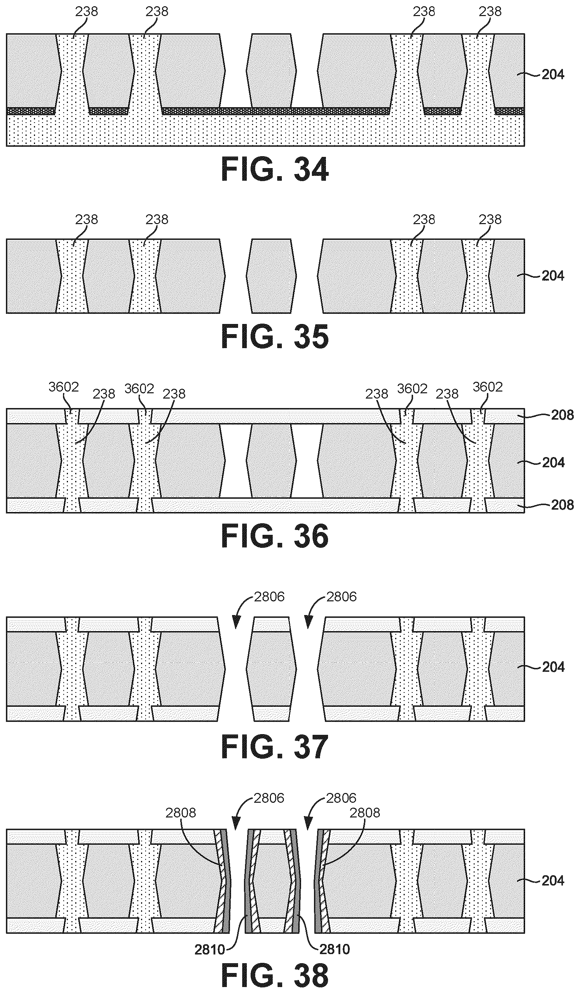

FIGS. 29-42 illustrate different stages in an example fabrication process to manufacture the example substrate core 2800 of FIG. 28. The stages of fabrication represented by FIGS. 29-35 are substantially the same as outlined above in connection with FIGS. 3-6 and 8-10 except as noted below and/or otherwise made clear from the context. That is, the process begins with a glass panel 2900 (corresponding to an initial state of the second glass core 204 in this example) as represented at FIG. 29. The glass core 204 is exposed to a laser as part of a LIDE process (FIG. 30) and then the laser-exposed portions of the glass core 204 are removed (FIG. 31) to define openings 3102 for the TGVs 238 and to define the openings 2806 for the PMVs 2802, 2804. Unlike what is shown in FIG. 5, in the illustrated example of FIG. 31, the openings 3102 are substantially the same size as the openings 2806. As represented in FIG. 32, the glass core 204 is attached to a conductive carrier. In some examples, the conductive carrier may be similar or identical to the conductive carrier 602 shown and described in connection with FIG. 6. Accordingly, the same reference numbers are used to identify similar features and the details provided above for such features apply similarly to this example. FIG. 33 represents the application of a mask 3302 (e.g., via photolithography) to cover the assembly except for the openings 3102 of the glass core 204. That is, the openings 2806 for the PMVs 2802, 2804 are covered, though they remain empty at this stage in the process. FIG. 33 further represents the results of an etching process to remove the release layer 606 exposed within the openings 3102. FIG. 34 represents the stage of fabrication following the removal (e.g., stripping) of the mask 802 and subsequent plating of copper within the openings 3102 to define the TGVs 238. FIG. 35 represents the stage of fabrication following the removal of the conductive carrier 602, including both the conductive layer 604 and the release layer 606. In some examples, a polishing (e.g., a CMP) process may be implemented to make the metal of the TGVs 238 substantially flush with the outer surfaces of the glass core 204.

FIG. 36 represents the stage of fabrication following the addition (e.g., lamination) of the dielectric material 208 onto both outer surfaces of the glass core 204 followed by the drilling of holes and the subsequent filling of such holes (e.g., by plating) to define metal vias electrically coupled to the TGVs 238. In some examples, a polishing (e.g., a CMP) process is implemented to remove excess metal and make the vias 3602 substantially flush with the dielectric material 208.

FIG. 37 represents the stage of fabrication following another drilling process through the dielectric material 208 to expose the openings 2806 for the PMVs 2802, 2804. FIG. 38 represents the stage of fabrication following the deposition of the seed layer 2808. In some examples, the seed layer 2808 is deposited to line the inner walls of the openings 2806 through any suitable deposition process (e.g., physical vapor deposition (PVD), atomic layer deposition (ALD), - e-less plating etc.). Further, FIG. 38 represents the subsequent application (e.g., through plating) of the magnetic material 2810 onto the seed layer 2808. In some examples, the seed layer 2808 and the magnetic material 2810 are also applied to the outer surfaces of the assembly (e.g., on the dielectric material 208 and the vias 3602). Accordingly, in some examples, the excess material deposited outside of the openings 2806 is removed (e.g., via etching, polishing, etc.).

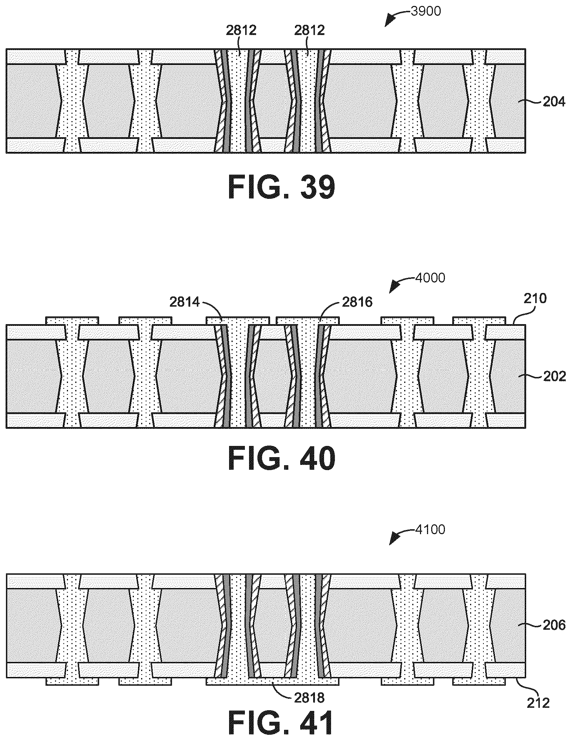

FIG. 39 represents the stage of fabrication following the plating of the conductive material 2812 (e.g., copper) to fill the openings 2806 and complete the structure of the relevant segment of the PMVs 2802, 2804. In some examples, excess portions of the conductive material 2812 are removed through a polishing process (e.g., a CMP process) to make the outer surfaces of the different materials substantially flush with one another. In some examples, the stage of fabrication represented by FIG. 39 corresponds to a complete glass core assembly 3900 at the end of processing of the second glass core 204 prior to being stacked with the other glass cores 202, 206 (that have been processed to include other segments of the PMVs 2802, 2804). In some examples, the first and third glass cores 202, 206 are processed in a similar manner to the second glass core 204 as outlined above. Thus, FIG. 40 represents a complete glass core assembly 4000 following completion of the processing of the first glass core 202, and FIG. 41 represents a complete glass core assembly 4100 following completion of the processing of the third glass core 206. As shown, the end result shown in FIG. 40 is substantially the same as the end result shown in FIG. 39, except that FIG. 40 follows the additional operations to provide the conductive pads 2814, 2816 onto one of the outer surfaces (e.g., the upper surface) of the assembly 4000. In this example, the outer surface corresponds to the first surface 210 of the substrate core 2800 of FIG. 28. Similarly, the end result shown in FIG. 41 is substantially the same as the end result shown in FIG. 39, except that FIG. 41 follows the additional operations to provide the conductive pads 2818 onto one of the outer surfaces (e.g., the bottom surface) of the assembly 4100. In this example, the outer surface corresponds to the second surface 212 of the substrate core 2800 of FIG. 28.

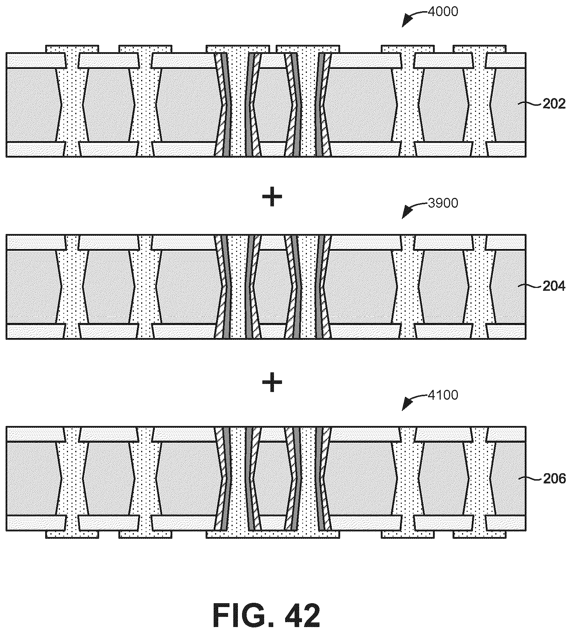

FIG. 42 represents the stage of fabrication when the three glass cores 202, 204, 206 are assembled or stacked together by combining or joining the associated glass core assemblies 3900, 4000, 4100 of FIGS. 39-41. In some examples, the same processes are used to join the glass core assemblies 3900, 4000, 4100 of FIGS. 39-41 as used to join the glass core assemblies 1500, 1600, 1700 of FIGS. 15-17 as discussed above in connection with FIG. 18. The result of combining or joining the different glass core assemblies 3900, 4000, 4100 produces the substrate core 2800 shown in FIG. 28.

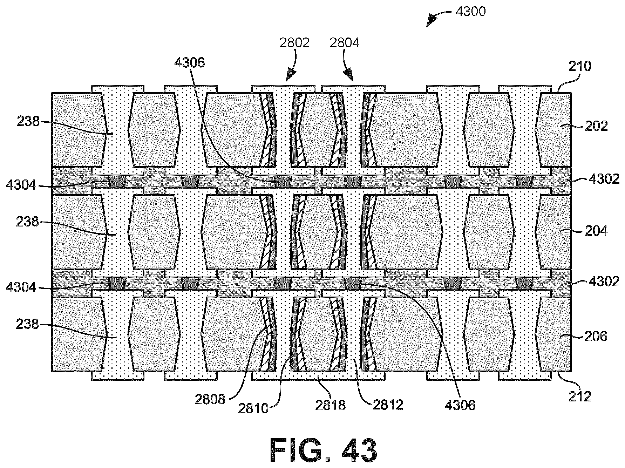

FIG. 43 illustrates another example substrate core 4300 that may be used to implement the example substrate core 128 of FIG. 1. The example substrate core 4300 of FIG. 43 is substantially the same as the example substrate core 2800 of FIG. 28 except as noted below. Accordingly, the features shown in FIG. 43 that are the same or similar to corresponding features in FIG. 28 (and associated FIGS. 29-42) are identified by the same reference numbers. Further, the description of such features described above in connection with FIG. 28 (and associated FIGS. 29-42) applies similarly with respect to the corresponding features in FIG. 43.

FIG. 43 differs from FIG. 28 by the omission of the dielectric material 208 on the outer surfaces of each of the glass cores 202, 204, 206. Further, FIG. 43 differs from FIG. 28 by the way the different glass cores 202, 204, 206 are combined or joined together and the resulting means for electrically coupling the different TGVs 238 and the different segments of the PMVs 2802, 2804. Specifically, as shown in the illustrated example of FIG. 43, the different cores 202, 204, 206 are joined together by an adhesive dielectric 4302 that extends between facing surfaces of adjacent ones of the glass cores 202, 204, 206. In some examples, the adhesive dielectric 4302 is substantially the same or similar to the adhesive dielectric 248 of FIG. 2B. Further, in this example, the TGVs 238 extending through the glass cores 202, 204, 206 are electrically coupled by conductive vias 4304 extending through the adhesive dielectric 4302. Similar conductive vias 4306 extend through the adhesive dielectric 4302 to electrically couple the conductive material 2812 associated with the different segments of the PMVs 2802, 2804. In some examples, the conductive vias 4304, 4306 are substantially the same or similar to the conductive vias 254, 256 of FIG. 2B.

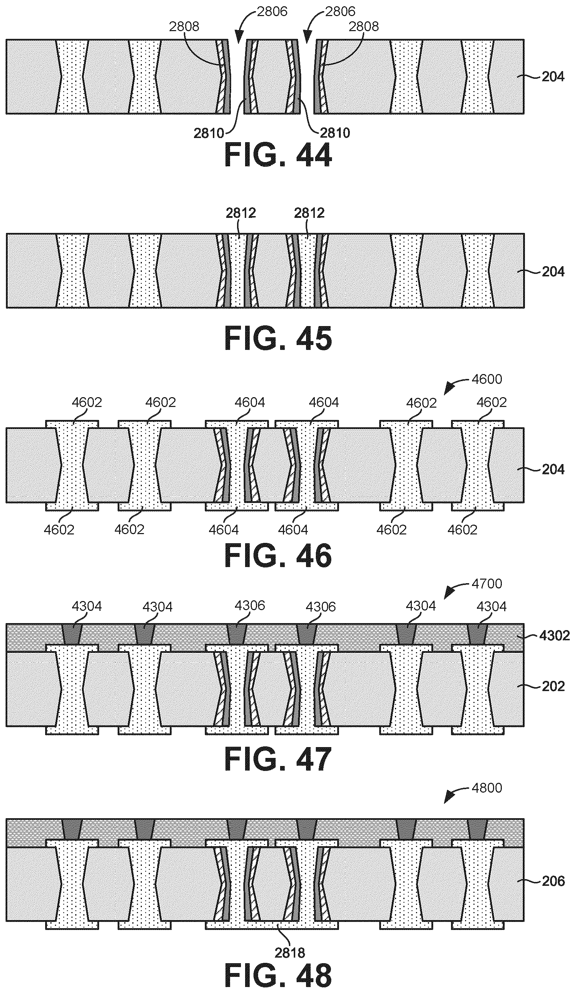

FIGS. 44-49 illustrate different stages in an example fabrication process to manufacture the example substrate core 4300 of FIG. 43. The process to fabricate the example substrate core 4300 of FIG. 43 can follow the same or similar processes detailed above in connection with the different stages of fabrication represented by FIGS. 29-35 discussed above in connection with FIG. 28. More particularly, FIG. 44 represents the stage of fabrication after the stage represented in FIG. 35 and following the deposition of the seed layer 2808 and the magnetic material 2810. In some examples, these layers are added using the same techniques discussed above in connection with FIG. 38, with the differences being that there are no layers of the dielectric material 208 in FIG. 44.

FIG. 45 represents the stage of fabrication following the plating of the conductive material 2812 (e.g., copper) similar to the processes described above in connection with FIG. 39. FIG. 46 represents the stage of fabrication following the addition of conductive pads 4602 (e.g., copper pads) to both ends of the TGVs 238 and conductive pads 4604 (e.g., copper pads) to both ends of the segments of the PMVs 2802, 2804. In some examples, the stage of fabrication represented by FIG. 46 corresponds to a complete glass core assembly 4600 at the end of processing of the second glass core 204 prior to being stacked with the other glass cores 202, 206 (that have been processed to include other segments of the PMVs 2802, 2804).

In some examples, the first and third glass cores 202, 206 are processed in a similar manner to the second glass core 204 as outlined above. Thus, FIG. 47 represents a complete glass core assembly 4700 following completion of the processing of the first glass core 202, and FIG. 48 represents a complete glass core assembly 4800 following completion of the processing of the third glass core 206. As shown, the end result shown in FIG. 47 is substantially the same as the end result shown in FIG. 46, except that FIG. 47 follows the additional operations to add the adhesive dielectric 4302 and the subsequent drilling and filling of holes to provide the conductive vias 4304, 4306. The end result shown in FIG. 48 is substantially the same as the end result shown in FIG. 47, except that the conductive pads on the bottom end of the segments of the PMVs 2802, 2804 are combined into a single conductive pad corresponding to the conductive pad 2818.

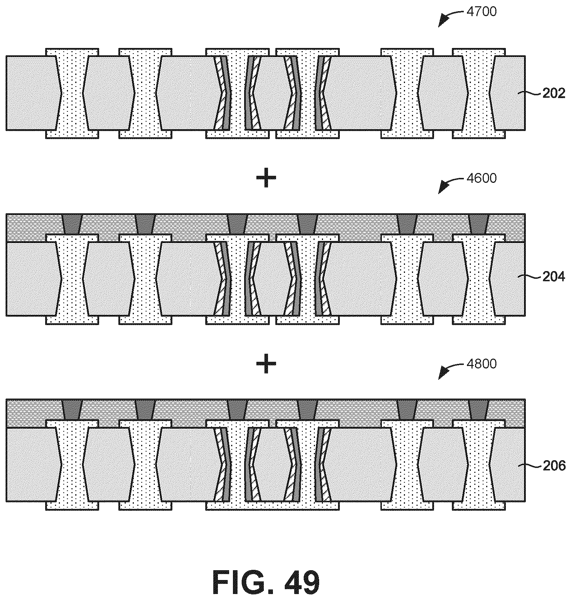

FIG. 49 represents the stage of fabrication when the three glass cores 202, 204, 206 are assembled or stacked together by combining or joining the associated glass core assemblies 4600, 4700, 4800 of FIGS. 46-48. In some examples, the same processes are used to join the glass core assemblies 4600, 4700, 4800 of FIGS. 46-48 as used to join the glass core assemblies 1500, 1600, 1700 of FIGS. 15-17 as discussed above in connection with FIG. 18. The result of combining or joining the different glass core assemblies 4600, 4700, 4800 produces the substrate core 4300 shown in FIG. 43.

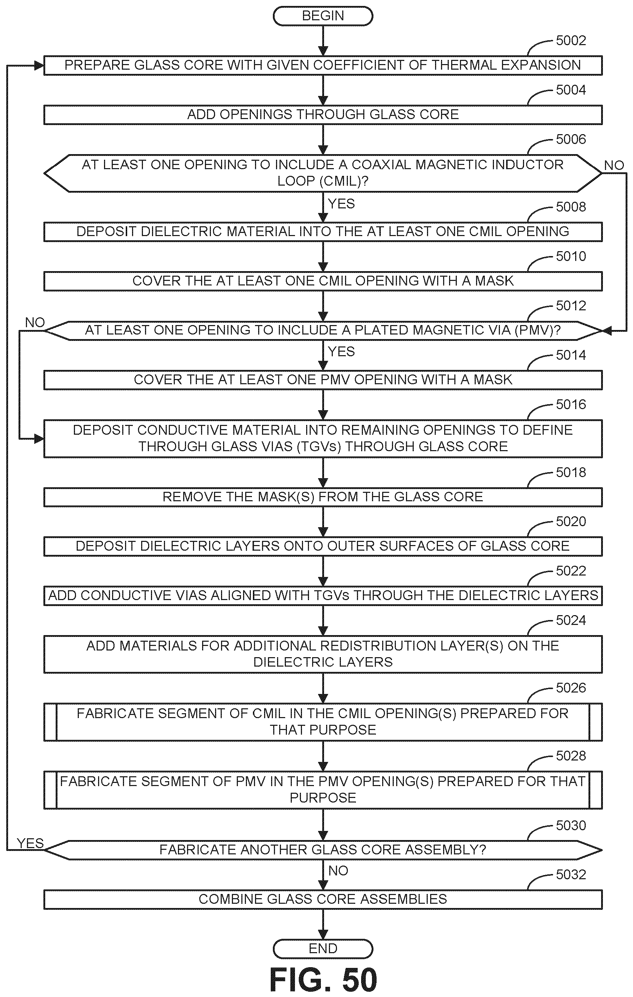

FIG. 50 is a flowchart representative of an example method that may be performed to fabricate any one of the example package substrate cores 128, 200, 244, 2700, 2708, 2800, 4300 of FIGS. 1-49. In some examples, some or all of the operations outlined in the example method of FIG. 50 are performed automatically by equipment that is programmed to perform the operations. Although the example method is described with reference to the flowchart illustrated in FIG. 50, many other methods may alternatively be used. For example, the order of execution of the blocks may be changed, and/or some of the blocks described may be combined, divided, re-arranged, omitted, eliminated, and/or implemented in any other way. Further, in some examples, additional processing operations can be performed before, between, and/or after any of the blocks represented in the illustrated example.

The example method of FIG. 50 begins at block 5002 by preparing a glass core (e.g., a glass panel 300, 2900 corresponding to anyone of the glass cores 202, 204, 206) with a given coefficient of thermal expansion (CTE). In some examples, the composition of materials used in the glass core is selected to achieve the CTE intended for a particular layer of glass within an overall substrate core that includes multiple glass cores stacked together. At block 5004, the example method includes adding openings through glass core (e.g., as represented in FIGS. 4-5 and 30-31). The openings can include openings for TGVs (e.g., the TGVs 238), CMILs (e.g., the CMILs 214, 246, 2702, 2710), and/or PMVs (e.g., the PMVs 2802, 2804).

At block 5006, the example method involves determining whether at least one of the openings is to include a CMIL. If so, the process advances to block 5008. Otherwise, the process advances to block 5012. At block 5008, the example process involves depositing a dielectric material (e.g., the dielectric material 208) into the at least one CMIL opening (e.g., as represented in FIG. 7). At block 5010, the example process involves covering the at least one CMIL opening with a mask (e.g., the mask 802 as represented in FIG. 8).

At block 5012, the example method involves determining whether at least one of the openings (added at block 5004) is to include a PMV. If so, the process advances to block 5014. Otherwise, the process advances to block 5016. At block 5014, the example process involves covering the at least one PMV opening with a mask (e.g., the mask 3302 as represented in FIG. 33).

At block 5016, the example method involves depositing conductive material into remaining openings to define TGVs (e.g., the TGVs 238) through glass core (e.g., as represented in FIGS. 9 and 34). At block 5018, the example method involves removing the mask(s) (added at block 5010 and/or block 5014) from the glass core. At block 5020, the example method involves depositing dielectric layers (e.g., the buffer layers 1102, 1104 of FIG. 11, the dielectric material 208 of FIG. 36) onto outer surfaces of glass core. In some examples, block 5022 is omitted (e.g., when fabricating the example substrate core 4300 of FIG. 43). At block 5022, the example method involves adding conductive vias (e.g., the conductive vias 3602) aligned with the TGVs through the dielectric layers (e.g., as represented in FIGS. 11 and 36). At block 5024, the example method involves adding materials for additional redistribution layer(s) (e.g., the conductive pads 1108, the additional dielectric layers 1202, the conductive blankets 1208 as represented in FIG. 12). In some examples, block 5024 is omitted (e.g., when fabricating the example substrate cores 244, 2708, 2800, 4300 of FIGS. 2B, 27B, 28, and 43).

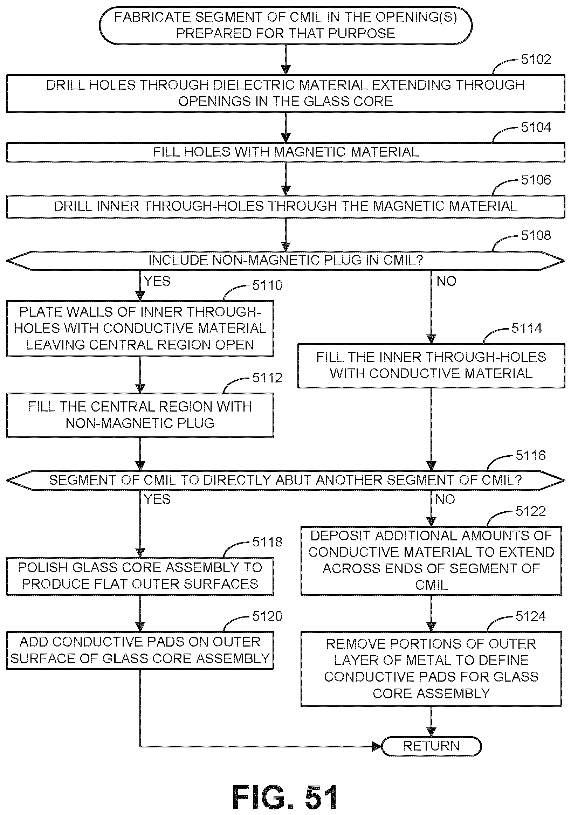

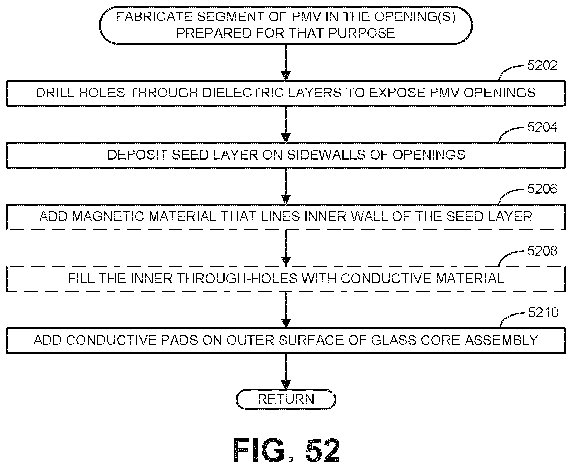

At block 5026, the example method involves fabricating a segment of the CMIL in the CMIL opening(s) prepared for that purpose. Further detail regarding the implementation of block 5026 is provided below in connection with FIG. 51. In examples where there are no CMIL openings (e.g., the result of block 5006 is NO), block 5026 can be omitted. At block 5028, the example method involves fabricating a segment of the PMV in the PMV opening(s) prepared for that purpose. Further detail regarding the implementation of block 5028 is provided below in connection with FIG. 52. In examples where there are no PMV openings (e.g., the result of block 5012 is NO), block 5028 can be omitted.

At block 5030, the example method involves determining whether to fabricate another glass core assembly (e.g., the glass core assemblies 1500, 1600, 1700, 1902, 1904, 1906, 2300, 2400, 2500, 3900, 4000, 4100, 4600, 4700, 4800). If so, the process returns to block 5002 to repeat the process for a different glass core. In some examples, the different glass core can be constructed with a different CTE. In some examples, the separate iterations through the example process can be performed in parallel rather than sequentially. Once there are no further glass core assemblies to fabricate, the example process advances to block 5032 that involves combining the glass core assemblies. In some examples, the glass core assemblies, as completed up to block 5028, are combined so that the segments of the CMIL and/or PMVs directly abut one another (as represented in FIGS. 18 and 42). In other examples, a dielectric adhesive (e.g., the adhesive dielectric 248, 4302) may be added onto at least one side of the interfacing surfaces of adjacent glass core assemblies to facilitate the connecting of the glass core assemblies (as represented in FIGS. 25, 26, and 47-49). In some such examples, additional conductive vias (e.g., the conductive vias 254, 256, 4304, 4306) are provided to extend through the dielectric adhesive.

In some examples, block 5026 and/or block 5028 (details of which are discussed further below in connection with FIGS. 51 and 52) can be implemented after block 5032. That is, in some examples, the glass core assemblies are fabricated and combined prior to including the CMILs and/or PMVs (as represented in FIG. 19) and then the CMILs and/or PMVs are added thereafter. The completion of the example process of FIG. 50 results in a completed substrate core (e.g., any one of the substrate cores 128, 200, 244, 2700, 2708, 2800, 4300). Thereafter, the completed substrate core may undergo any suitable subsequent processing (e.g., adding build-up layers, attaching one or more dies, and implementing other packaging processes).

FIG. 51 is a flowchart representative of an example method to implement block 5026 of FIG. 50. In some examples, some or all of the operations outlined in the example method of FIG. 51 are performed automatically by equipment that is programmed to perform the operations. Although the example method is described with reference to the flowchart illustrated in FIG. 51, many other methods may alternatively be used. For example, the order of execution of the blocks may be changed, and/or some of the blocks described may be combined, divided, re-arranged, omitted, eliminated, and/or implemented in any other way. Further, in some examples, additional processing operations can be performed before, between, and/or after any of the blocks represented in the illustrated example.

The example method of FIG. 51 begins at block 5102 by drilling holes (e.g., the holes 1302) through dielectric material (e.g., the dielectric material 208) extending through openings (e.g., the openings 216, 218, 220) in the glass core. At block 5104, the example method involves filling the holes with magnetic material (e.g., the magnetic material 230). At block 5106, the example method involves drilling inner through-holes (e.g., the inner through-holes 1402) through the magnetic material. At block 5108, the example method involves determining whether to include a non-magnetic plug in CMIL. If so, the process advances to block 5110. Otherwise, the example process advances to block 5114.

At block 5110, the example method involves plating the walls of inner through-holes with a conductive material (e.g., the conductive material 228) while leaving a central region open. At block 5112, the example method involves filling the central region with a non-magnetic plug (e.g., the non-magnetic plug 226). Thereafter, the example process advances to block 5116. Returning to block 5114, the example process involves filling the inner through-holes with the conductive material. Thereafter, the example processes advances to block 5116, which involves determining whether the segment of the CMIL being fabricated is to directly but another segment of the CMIL (e.g., as shown in example substrate cores FIG. 18 and 42 in contrast with examples where the segments are spaced apart by the adhesive dielectric 248, 4302 as shown in FIGS. 26 and 49). If so, the process advances to block 5118.

At block 5118, the example method involves polishing the glass core assembly to produce flat outer surfaces. At block 5120, the example method involves adding conductive pads (e.g., the conductive pads 232, 234, 236, 1602, 1702, 2814, 2816, 2818, 4602, 4604) on outer surfaces of the resulting glass core assembly. In some examples, conductive pads are added to only one of the two surfaces (as represented in FIGS. 16 and 17). In some examples, no conductive pads are added (as represented in FIGS. 15 and 19). In some examples, whether conductive pads are added to both, one, or neither outer surface of the glass core depends on where the glass core is to be located in the stack of glass cores and the manner in which the different glass cores are combined or joined in the stack. Thereafter, the example process of FIG. 51 ends and returns to complete the example process of FIG. 50.

Returning to block 5116, if the segment of the CMIL being fabricated is not to directly abut another segment of the CMIL, the example method advances to block 5122. At block 5122, the example method involves depositing additional amounts of conductive material 228 to extend across ends of the segment of the CMIL. At block 5124, the example method involves removing portions of the outer layers of metal to define conductive pads (e.g., the conductive pads 232, 234, 236, 1602, 1702, 2814, 2816, 2818, 4602, 4604). In this example, the conductive pads are added to both sides of the glass core assembly (e.g., to cap off both ends of the CMIL as shown in FIG. 24). Thereafter, the example process of FIG. 51 ends and returns to complete the example process of FIG. 50.

FIG. 52 is a flowchart representative of an example method to implement block 5028 of FIG. 50. In some examples, some or all of the operations outlined in the example method of FIG. 52 are performed automatically by equipment that is programmed to perform the operations. Although the example method is described with reference to the flowchart illustrated in FIG. 52, many other methods may alternatively be used. For example, the order of execution of the blocks may be changed, and/or some of the blocks described may be combined, divided, re-arranged, omitted, eliminated, and/or implemented in any other way. Further, in some examples, additional processing operations can be performed before, between, and/or after any of the blocks represented in the illustrated example.

The example method of FIG. 52 begins at block 5202 by drilling holes through dielectric layers (added at block 5020 of FIG. 50) to expose the PMV openings (as represented in FIG. 37). At block 5204, the example method involves depositing a seed layer (e.g., the seed layer 2808) on sidewalls of openings (as represented in FIGS. 38 and 44). At block 5206, the example method involves adding a magnetic material (e.g., the magnetic material 2810) that lines inner wall of the seed layer (as represented in FIGS. 38 and 44). At block 5208, the example method involves filling the inner through-holes with a conductive material (e.g., the conductive material 2812 as represented in FIGS. 39 and 45). At block 5210, the example method involves adding conductive pads (e.g., the conductive pads 232, 234, 236, 1602, 1702, 2814, 2816, 2818, 4602, 4604) on outer surfaces of the resulting glass core assembly. In some examples, conductive pads are added to only one of the two surfaces (as represented in FIGS. 40 and 41). In some examples, the conductive pads are added to both surfaces (as represented in FIGS. 46-48). In some examples, no conductive pads are added (as represented in FIG. 39). In some examples, whether conductive pads are added to both, one, or neither outer surface of the glass core depends on where the glass core is to be located in the stack of glass cores and the manner in which the different glass cores are combined or joined in the stack. Thereafter, the example process of FIG. 52 ends and returns to complete the example process of FIG. 50.

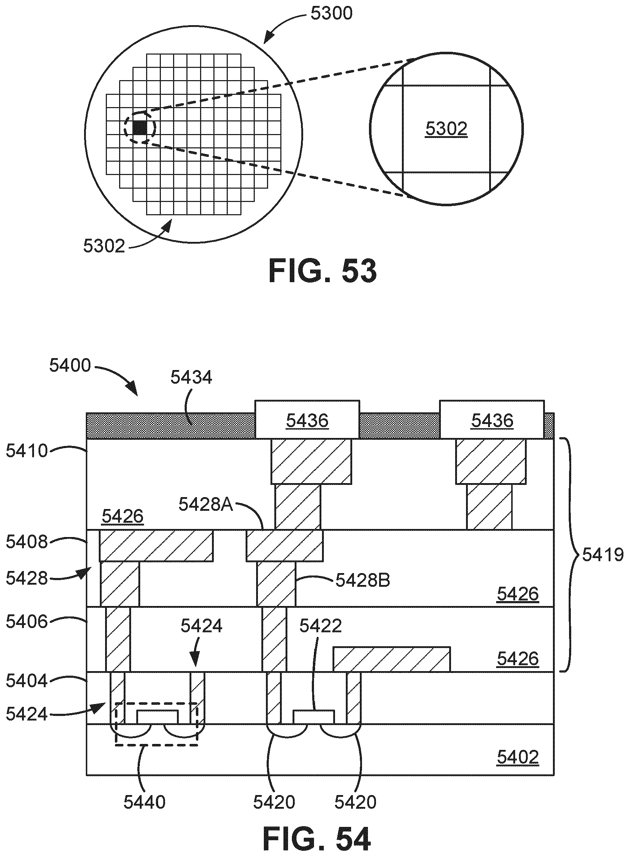

The example IC package 100 of FIG. 1 (with any of the example substrate cores 128, 200, 244, 2700, 2708, 2800, 4300) disclosed herein may be included in any suitable electronic component. FIGS. 53-56 illustrate various examples of apparatus that may include or be included in the IC package 100 disclosed herein.

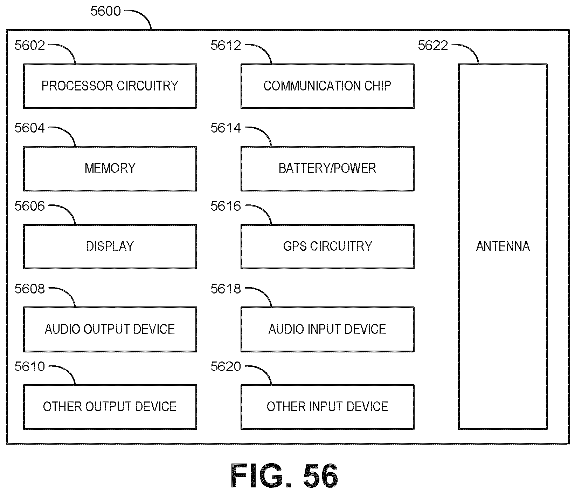

FIG. 53 is a top view of a wafer 5300 and dies 5302 that may be included in the IC package 100 of FIG. 1 (e.g., as any suitable ones of the dies 106, 108). The wafer 5300 includes semiconductor material and one or more dies 5302 having circuitry. Each of the dies 5302 may be a repeating unit of a semiconductor product. After the fabrication of the semiconductor product is complete, the wafer 5300 may undergo a singulation process in which the dies 5302 are separated from one another to provide discrete "chips." The die 5302 includes one or more transistors (e.g., some of the transistors 5440 of FIG. 54, discussed below), supporting circuitry to route electrical signals to the transistors, passive components (e.g., traces, resistors, capacitors, inductors, and/or other circuitry), and/or any other components. In some examples, the die 5302 may include and/or implement a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuitry or electronics. Multiple ones of these devices may be combined on a single die 5302. For example, a memory array of multiple memory circuits may be formed on a same die 5302 as programmable circuitry (e.g., the processor circuitry 5602 of FIG. 56) and/or other logic circuitry. Such memory may store information for use by the programmable circuitry. The example IC package 100 disclosed herein may be manufactured using a die-to-wafer assembly technique in which some dies are attached to a wafer 5300 that includes others of the dies, and the wafer 5300 is subsequently singulated.

FIG. 54 is a cross-sectional side view of an IC device 2000 that may be included in the example IC package 100 (e.g., in any one of the dies 106, 108). One or more of the IC devices 5400 may be included in one or more dies 5302 (FIG. 53). The IC device 5400 may be formed on a die substrate 5402 (e.g., the wafer 5300 of FIG. 53) and may be included in a die (e.g., the die 5302 of FIG. 53). The die substrate 5402 may be a semiconductor substrate including semiconductor materials including, for example, n-type or p-type materials systems (or a combination of both). The die substrate 5402 may include, for example, a crystalline substrate formed using a bulk silicon or a silicon-on-insulator (SOI) substructure. In some examples, the die substrate 5402 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the die substrate 5402. Although a few examples of materials from which the die substrate 5402 may be formed are described here, any material that may serve as a foundation for an IC device 5400 may be used. The die substrate 5402 may be part of a singulated die (e.g., the dies 5302 of FIG. 53) or a wafer (e.g., the wafer 5300 of FIG. 53).

The IC device 5400 may include one or more device layers 5404 disposed on and/or above the die substrate 5402. The device layer 5404 may include features of one or more transistors 5440 (e.g., metal oxide semiconductor field-effect transistors (MOSFETs)) formed on the die substrate 5402. The device layer 5404 may include, for example, one or more source and/or drain (S/D) regions 5420, a gate 5422 to control current flow between the S/D regions 5420, and one or more S/D contacts 5424 to route electrical signals to/from the S/D regions 5420. The transistors 5440 may include additional features not depicted for the sake of clarity, such as device isolation regions, gate contacts, and the like. The transistors 5440 are not limited to the type and configuration depicted in FIG. 54 and may include a wide variety of other types and/or configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 5440 may include a gate 5422 including a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and/or zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and/or lead zinc niobate. In some examples, an annealing process may be carried out on the gate dielectric to improve its quality when a high-k material is used.

The gate electrode may be formed on the gate dielectric and may include at least one p-type work function metal or n-type work function metal, depending on whether the transistor 5440 is to be a p-type metal oxide semiconductor (PMOS) or an n-type metal oxide semiconductor (NMOS) transistor. In some implementations, the gate electrode may include a stack of two or more metal layers, where one or more metal layers are work function metal layers and at least one metal layer is a fill metal layer. Further metal layers may be included, such as a barrier layer. For a PMOS transistor, metals that may be used for the gate electrode include, but are not limited to, ruthenium, palladium, platinum, cobalt, nickel, conductive metal oxides (e.g., ruthenium oxide), and/or any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and/or aluminum carbide), and/or any of the metals discussed above with reference to a PMOS transistor (e.g., for work function tuning).

In some examples, when viewed as a cross-section of the transistor 5440 along the source-channel-drain direction, the gate electrode may include a U-shaped structure that includes a bottom portion substantially parallel to the surface of the die substrate 5402 and two sidewall portions that are substantially perpendicular to the top surface of the die substrate 5402. In other examples, at least one of the metal layers that form the gate electrode may be a planar layer that is substantially parallel to the top surface of the die substrate 5402 and does not include sidewall portions substantially perpendicular to the top surface of the die substrate 5402. In other examples, the gate electrode may include a combination of U-shaped structures and/or planar, non-U-shaped structures. For example, the gate electrode may include one or more U-shaped metal layers formed atop one or more planar, non-U-shaped layers.

In some examples, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and/or silicon oxynitride. Processes for forming sidewall spacers are well known in the art and generally include deposition and etching process operations. In some examples, a plurality of spacer pairs may be used; for instance, two pairs, three pairs, or four pairs of sidewall spacers may be formed on opposing sides of the gate stack.

The S/D regions 5420 may be formed within the die substrate 5402 adjacent to the gate 5422 of corresponding transistor(s) 5440. The S/D regions 5420 may be formed using an implantation/diffusion process or an etching/deposition process, for example. In the former process, dopants such as boron, aluminum, antimony, phosphorous, or arsenic may be ion-implanted into the die substrate 5402 to form the S/D regions 5420. An annealing process that activates the dopants and causes them to diffuse farther into the die substrate 5402 may follow the ion-implantation process. In the latter process, the die substrate 5402 may first be etched to form recesses at the locations of the S/D regions 5420. An epitaxial deposition process may then be carried out to fill the recesses with material that is used to fabricate the S/D regions 5420. In some implementations, the S/D regions 5420 may be fabricated using a silicon alloy such as silicon germanium or silicon carbide. In some examples, the epitaxially deposited silicon alloy may be doped in situ with dopants such as boron, arsenic, or phosphorous. In some examples, the S/D regions 5420 may be formed using one or more alternate semiconductor materials such as germanium or a group III-V material or alloy. In further examples, one or more layers of metal and/or metal alloys may be used to form the S/D regions 5420.

Electrical signals, such as power and/or input/output (I/O) signals, may be routed to and/or from the devices (e.g., transistors 5440) of the device layer 5404 through one or more interconnect layers disposed on the device layer 5404 (illustrated in FIG. 54 as interconnect layers 5406-5410). For example, electrically conductive features of the device layer 5404 (e.g., the gate 5422 and the S/D contacts 5424) may be electrically coupled with the interconnect structures 5428 of the interconnect layers 5406-5410. The one or more interconnect layers 5406-5410 may form a metallization stack (also referred to as an "ILD stack") 5419 of the IC device 5400.

The interconnect structures 5428 may be arranged within the interconnect layers 5406-5410 to route electrical signals according to a wide variety of designs (in particular, the arrangement is not limited to the particular configuration of interconnect structures 5428 depicted in FIG. 54). Although a particular number of interconnect layers 5406-5410 is depicted in FIG. 54, examples of the present disclosure include IC devices having more or fewer interconnect layers than depicted.

In some examples, the interconnect structures 5428 may include lines 5428a and/or vias 5428b filled with an electrically conductive material such as a metal. The lines 5428a may be arranged to route electrical signals in a direction of a plane that is substantially parallel with a surface of the die substrate 5402 upon which the device layer 5404 is formed. For example, the lines 5428a may route electrical signals in a direction in and/or out of the page from the perspective of FIG. 54. The vias 5428b may be arranged to route electrical signals in a direction of a plane that is substantially perpendicular to the surface of the die substrate 5402 upon which the device layer 5404 is formed. In some examples, the vias 5428b may electrically couple lines 5428a of different interconnect layers 5406-5410 together.

The interconnect layers 5406-5410 may include a dielectric material 5426 disposed between the interconnect structures 5428, as shown in FIG. 54. In some examples, the dielectric material 5426 disposed between the interconnect structures 5428 in different ones of the interconnect layers 5406-5410 may have different compositions; in other examples, the composition of the dielectric material 5426 between different interconnect layers 5406-5410 may be the same.

A first interconnect layer 5406 (referred to as Metal 1 or "M1") may be formed directly on the device layer 5404. In some examples, the first interconnect layer 5406 may include lines 5428a and/or vias 5428b, as shown. The lines 5428a of the first interconnect layer 5406 may be coupled with contacts (e.g., the S/D contacts 5424) of the device layer 5404.

A second interconnect layer 5408 (referred to as Metal 2 or "M2") may be formed directly on the first interconnect layer 5406. In some examples, the second interconnect layer 5408 may include vias 5428b to couple the lines 5428a of the second interconnect layer 5408 with the lines 5428a of the first interconnect layer 5406. Although the lines 5428a and the vias 5428b are structurally delineated with a line within each interconnect layer (e.g., within the second interconnect layer 5408) for the sake of clarity, the lines 5428a and the vias 5428b may be structurally and/or materially contiguous (e.g., simultaneously filled during a dual-damascene process) in some examples.

A third interconnect layer 5410 (referred to as Metal 3 or "M3") (and additional interconnect layers, as desired) may be formed in succession on the second interconnect layer 5408 according to similar techniques and/or configurations described in connection with the second interconnect layer 5408 or the first interconnect layer 5406. In some examples, the interconnect layers that are "higher up" in the metallization stack 5419 in the IC device 5400 (i.e., further away from the device layer 5404) may be thicker.

The IC device 5400 may include a solder resist material 5434 (e.g., polyimide or similar material) and one or more conductive contacts 5436 formed on the interconnect layers 5406-5410. In FIG. 54, the conductive contacts 5436 are illustrated as taking the form of bond pads. The conductive contacts 5436 may be electrically coupled with the interconnect structures 5428 and configured to route the electrical signals of the transistor(s) 5440 to other external devices. For example, solder bonds may be formed on the one or more conductive contacts 5436 to mechanically and/or electrically couple a chip including the IC device 5400 with another component (e.g., a circuit board). The IC device 5400 may include additional or alternate structures to route the electrical signals from the interconnect layers 5406-5410; for example, the conductive contacts 5436 may include other analogous features (e.g., posts) that route the electrical signals to external components.

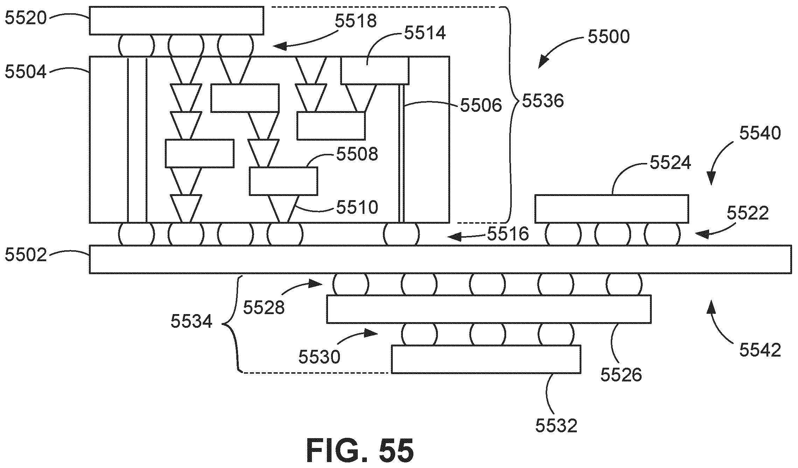

FIG. 55 is a cross-sectional side view of an IC device assembly 5500 that may include the IC package 100 disclosed herein. In some examples, the IC device assembly corresponds to the IC package 100. The IC device assembly 5500 includes a number of components disposed on a circuit board 5502 (which may be, for example, a motherboard). The IC device assembly 5500 includes components disposed on a first face 5540 of the circuit board 5502 and an opposing second face 5542 of the circuit board 5502; generally, components may be disposed on one or both faces 5540 and 5542. Any of the IC packages discussed below with reference to the IC device assembly 2200 may take the form of the example IC package 100 of FIG. 1.

In some examples, the circuit board 5502 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 5502. In other examples, the circuit board 5502 may be a non-PCB substrate.

The IC device assembly 5500 illustrated in FIG. 55 includes a package-on-interposer structure 5536 coupled to the first face 5540 of the circuit board 5502 by coupling components 5516. The coupling components 5516 may electrically and mechanically couple the package-on-interposer structure 5536 to the circuit board 5502, and may include solder balls (as shown in FIG. 55), male and female portions of a socket, an adhesive, an underfill material, and/or any other suitable electrical and/or mechanical coupling structure.

The package-on-interposer structure 5536 may include an IC package 5520 coupled to an interposer 5504 by coupling components 5518. The coupling components 5518 may take any suitable form for the application, such as the forms discussed above with reference to the coupling components 5516. Although a single IC package 5520 is shown in FIG. 55, multiple IC packages may be coupled to the interposer 5504; indeed, additional interposers may be coupled to the interposer 5504. The interposer 5504 may provide an intervening substrate used to bridge the circuit board 5502 and the IC package 5520. The IC package 5520 may be or include, for example, a die (the die 5302 of FIG. 53), an IC device (e.g., the IC device 5400 of FIG. 54), or any other suitable component. Generally, the interposer 5504 may spread a connection to a wider pitch or reroute a connection to a different connection. For example, the interposer 5504 may couple the IC package 5520 (e.g., a die) to a set of BGA conductive contacts of the coupling components 5516 for coupling to the circuit board 5502. In the example illustrated in FIG. 55, the IC package 5520 and the circuit board 5502 are attached to opposing sides of the interposer 5504; in other examples, the IC package 5520 and the circuit board 5502 may be attached to a same side of the interposer 5504. In some examples, three or more components may be interconnected by way of the interposer 5504.

In some examples, the interposer 5504 may be formed as a PCB, including multiple metal layers separated from one another by layers of dielectric material and interconnected by electrically conductive vias. In some examples, the interposer 5504 may be formed of an epoxy resin, a fiberglass-reinforced epoxy resin, an epoxy resin with inorganic fillers, a ceramic material, or a polymer material such as polyimide. In some examples, the interposer 5504 may be formed of alternate rigid or flexible materials that may include the same materials described above for use in a semiconductor substrate, such as silicon, germanium, and other group III-V and group IV materials. The interposer 5504 may include metal interconnects 5508 and vias 5510, including but not limited to through-silicon vias (TSVs) 5506. The interposer 5504 may further include embedded devices 5514, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 5504. The package-on-interposer structure 5536 may take the form of any of the package-on-interposer structures known in the art.

The IC device assembly 5500 may include an IC package 5524 coupled to the first face 5540 of the circuit board 5502 by coupling components 5522. The coupling components 5522 may take the form of any of the examples discussed above with reference to the coupling components 5516, and the IC package 5524 may take the form of any of the examples discussed above with reference to the IC package 5520.

The IC device assembly 5500 illustrated in FIG. 55 includes a package-on-package structure 5534 coupled to the second face 5542 of the circuit board 5502 by coupling components 5528. The package-on-package structure 5534 may include a first IC package 5526 and a second IC package 5532 coupled together by coupling components 5530 such that the first IC package 5526 is disposed between the circuit board 5502 and the second IC package 5532. The coupling components 5528, 5530 may take the form of any of the examples of the coupling components 5516 discussed above, and the IC packages 5526, 5532 may take the form of any of the examples of the IC package 5520 discussed above. The package-on-package structure 5534 may be configured in accordance with any of the package-on-package structures known in the art.

FIG. 56 is a block diagram of an example electrical device 5600 that may include one or more of the example IC package 100. For example, any suitable ones of the components of the electrical device 5600 may include one or more of the device assemblies 5500, IC devices 5400, or dies 5302 disclosed herein, and may be arranged in the example IC package 100. A number of components are illustrated in FIG. 56 as included in the electrical device 5600, but any one or more of these components may be omitted or duplicated, as suitable for the application. In some examples, some or all of the components included in the electrical device 5600 may be attached to one or more motherboards. In some examples, some or all of these components are fabricated onto a single system-on-a-chip (SoC) die.

Additionally, in various examples, the electrical device 5600 may not include one or more of the components illustrated in FIG. 56, but the electrical device 5600 may include interface circuitry for coupling to the one or more components. For example, the electrical device 5600 may not include a display 5606, but may include display interface circuitry (e.g., a connector and driver circuitry) to which a display 5606 may be coupled. In another set of examples, the electrical device 5600 may not include an audio input device 5618 (e.g., microphone) or an audio output device 5608 (e.g., a speaker, a headset, earbuds, etc.), but may include audio input or output device interface circuitry (e.g., connectors and supporting circuitry) to which an audio input device 5618 or audio output device 5608 may be coupled.

The electrical device 5600 may include programmable circuitry 5602 (e.g., one or more processing devices). The programmable circuitry 5602 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 5600 may include a memory 5604, which may itself include one or more memory devices such as volatile memory (e.g., dynamic random access memory (DRAM)), nonvolatile memory (e.g., read-only memory (ROM)), flash memory, solid state memory, and/or a hard drive. In some examples, the memory 5604 may include memory that shares a die with the programmable circuitry 5602. This memory may be used as cache memory and may include embedded dynamic random access memory (eDRAM) or spin transfer torque magnetic random access memory (STT-MRAM).

In some examples, the electrical device 5600 may include a communication chip 5612 (e.g., one or more communication chips). For example, the communication chip 5612 may be configured for managing wireless communications for the transfer of data to and from the electrical device 5600. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some examples they might not.

The communication chip 5612 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 5612 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 5612 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 5612 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 5612 may operate in accordance with other wireless protocols in other examples. The electrical device 5600 may include an antenna 5622 to facilitate wireless communications and/or to receive other wireless communications (such as AM or FM radio transmissions).

In some examples, the communication chip 5612 may manage wired communications, such as electrical, optical, or any other suitable communication protocols (e.g., the Ethernet). As noted above, the communication chip 5612 may include multiple communication chips. For instance, a first communication chip 5612 may be dedicated to shorter-range wireless communications such as Wi-Fi or Bluetooth, and a second communication chip 5612 may be dedicated to longer-range wireless communications such as global positioning system (GPS), EDGE, GPRS, CDMA, WiMAX, LTE, EV-DO, or others. In some examples, a first communication chip 5612 may be dedicated to wireless communications, and a second communication chip 5612 may be dedicated to wired communications.

The electrical device 5600 may include battery/power circuitry 5614. The battery/power circuitry 5614 may include one or more energy storage devices (e.g., batteries or capacitors) and/or circuitry for coupling components of the electrical device 5600 to an energy source separate from the electrical device 5600 (e.g., AC line power).

The electrical device 5600 may include a display 5606 (or corresponding interface circuitry, as discussed above). The display 5606 may include any visual indicators, such as a heads-up display, a computer monitor, a projector, a touchscreen display, a liquid crystal display (LCD), a light-emitting diode display, or a flat panel display.

The electrical device 5600 may include an audio output device 5608 (or corresponding interface circuitry, as discussed above). The audio output device 5608 may include any device that generates an audible indicator, such as speakers, headsets, or earbuds.

The electrical device 5600 may include an audio input device 5618 (or corresponding interface circuitry, as discussed above). The audio input device 5618 may include any device that generates a signal representative of a sound, such as microphones, microphone arrays, or digital instruments (e.g., instruments having a musical instrument digital interface (MIDI) output).

The electrical device 5600 may include GPS circuitry 5616. The GPS circuitry 5616 may be in communication with a satellite-based system and may receive a location of the electrical device 5600, as known in the art.

The electrical device 5600 may include any other output device 5610 (or corresponding interface circuitry, as discussed above). Examples of the other output device 5610 may include an audio codec, a video codec, a printer, a wired or wireless transmitter for providing information to other devices, or an additional storage device.

The electrical device 5600 may include any other input device 5620 (or corresponding interface circuitry, as discussed above). Examples of the other input device 5620 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 5600 may have any desired form factor, such as a hand-held or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server or other networked computing component, a printer, a scanner, a monitor, a set-top box, an entertainment control unit, a vehicle control unit, a digital camera, a digital video recorder, or a wearable electrical device. In some examples, the electrical device 5600 may be any other electronic device that processes data.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein "substantially real time" refers to occurrence in a near instantaneous manner recognizing there may be real world delays for computing time, transmission, etc. Thus, unless otherwise specified, "substantially real time" refers to real time + 1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that enable the fabrication of CMILs and/or PMVs for enhanced power delivery within substrate cores containing a stack of multiple disaggregated glass cores with different CTEs. The different CTEs define a CTE gradient that reduces stress within package substrates and, specifically, mitigates against seware failures that are known to arise in substrate with a single, solid glass core with a single CTE. As a result, examples disclosed herein improve yield loss in the fabrication of package substrates and also improve the reliability and/or useful life of IC packages relative to known techniques.

Further examples and combinations thereof include the following:
Example 1 includes a substrate for an integrated circuit package, the substrate comprising a first glass layer having a first coefficient of thermal expansion (CTE), a second glass layer having a second CTE, the second CTE different from the first CTE, a conductive material extending at least partly through a first hole in the first glass layer and a second hole in the second glass layer, and a magnetic material between an inner wall of the first hole and the conductive material.
Example 2 includes the substrate of example 1, wherein the conductive material and the magnetic material define a coaxial magnetic inductor loop (CMIL).
Example 3 includes the substrate of example 2, further including a non-magnetic plug within the CMIL, the conductive material surrounding the non-magnetic plug, and the magnetic material surrounding the conductive material.
Example 4 includes the substrate of any one of examples 2 or 3, wherein the CMIL is a first CMIL, the substrate includes a second CMIL adjacent the first CMIL, and both the first and second CMILs respectively extend through the first and second holes of the respective first and second glass layers.
Example 5 includes the substrate of any one of examples 1-4, further including a dielectric material between the first glass layer and the second glass layer.
Example 6 includes the substrate of example 5, wherein the dielectric material has a lower modulus of elasticity than the first glass layer.
Example 7 includes the substrate of any one of examples 5 or 6, wherein the dielectric material includes an organic dielectric.
Example 8 includes the substrate of example 7, wherein the dielectric material includes at least one of parylene or polyimide.
Example 9 includes the substrate of any one of examples 5-8, wherein the dielectric material includes an inorganic dielectric.
Example 10 includes the substrate of example 9, wherein the dielectric material includes at least one of silicon, oxygen, or nitrogen.
Example 11 includes an integrated circuit (IC) package comprising a first build-up region, a second build-up region, a stack of multiple glass layers between the first and second build-up regions, different ones of the glass layers having different coefficients of thermal expansion (CTEs), and a power delivery interconnect through the stack of multiple glass layers, the power delivery interconnect including at least one of nickel, iron, or cobalt.
Example 12 includes the IC package of example 11, wherein the glass layers include a first glass layer with a first CTE, a second glass layer with a second CTE, and a third glass layer with a third CTE, the second glass layer distinct from the first glass layer, the third glass layer distinct from the first glass layer and distinct from the second glass layer.
Example 13 includes the IC package of example 12, wherein the first glass layer is adjacent the first build-up region, the second glass layer is adjacent the second build-up region, and the third glass layer is between the first glass layer and the second glass layer, the first build-up region having a fifth CTE, and the second build-up region having a sixth CTE, the first CTE closer to the fifth CTE than the third CTE is to the fifth CTE, the second CTE closer to the sixth CTE than the third CTE is to the sixth CTE.
Example 14 includes the IC package of example 13, further including a fourth glass layer between the first glass layer and the third glass layer, the fourth glass layer having a seventh CTE between the first CTE and the third CTE.
Example 15 includes the IC package of any one of examples 12-14, wherein the second CTE corresponds to the first CTE, and the first CTE is higher than the third CTE.
Example 16 includes the IC package of any one of examples 12-15, wherein the third glass layer has a third CTE that is different from the first CTE and different from the second CTE.
Example 17 includes the IC package of any one of examples 12-16, wherein the different CTEs of the glass layers define a symmetrical CTE gradient.
Example 18 includes an apparatus comprising a semiconductor die, a package substrate supporting the semiconductor die, the package substrate including a stack of glass layers, a first one of the glass layers having a different coefficient of thermal expansion (CTE) from a second one of the glass layers, and a magnetic inductor extending through the stack of glass layers, the magnetic inductor including a non-magnetic core.
Example 19 includes the apparatus of example 18, wherein a first segment of the non-magnetic core extends through a first hole through the first glass layer and a second segment of the non-magnetic core extends through a second hole through the second glass layer.
Example 20 includes the apparatus of example 19, further including a magnetic material surrounding the non-magnetic core, the magnetic material extending continuously from within the first hole of the first glass layer to within the second hole in the second glass layer.
Example 21 includes a package substrate comprising a first glass layer, the first glass layer having a first coefficient of thermal expansion (CTE), the first glass layer having a first opening extending therethrough, a second glass layer, the second glass layer having a second CTE different from the first CTE, the second glass layer having a second opening extending therethrough, a first metal segment extending at least partly through the first opening, a second metal segment extending at least partly through the second opening, the first metal segment electrically coupled to the second metal segment, a first magnetic lining in the first opening, the first magnetic lining surrounding the first metal segment, and a second magnetic lining in the second opening, the second magnetic lining surrounding the second metal segment.
Example 22 includes the package substrate of example 21, wherein the first and second metal segments and the first and second magnetic linings define a coaxial magnetic inductor loop (CMIL).
Example 23 includes the package substrate of example 22, wherein the first metal segment extends continuously from an inner surface of the first magnetic lining to a central axis of a longitudinal length of the first metal segment.
Example 24 includes the package substrate of any one of examples 22 or 23, wherein the CMIL is a first CMIL, the substrate includes a second CMIL adjacent the first CMIL, and both the first and second CMILs respectively extend through the first and second glass layers.
Example 25 includes the package substrate of any one of examples 21-24, further including a dielectric material between the first glass layer and the second glass layer.
Example 26 includes the package substrate of example 25, wherein the dielectric material includes an epoxy.
Example 27 includes an integrated circuit (IC) package comprising a package core including a first glass sheet and a second glass sheet distinct from the first glass sheet, the first glass sheet having a different coefficient of thermal expansion (CTE) from the second glass sheet, a first redistribution layer on a first side of the package core, a second redistribution layer on a second side of the package core, the second side opposite the first side, and an interconnect extending through the package core, the interconnect including a magnetic material.
Example 28 includes the IC package of example 27, wherein the first glass sheet includes a first opening and the second glass sheet includes a second opening, and the interconnect extends through the first opening and the second opening, the IC package further including a dielectric material within the first opening, the dielectric material to surround the magnetic material.
Example 29 includes the IC package of example 28, further including a buffer material between the first glass sheet and the second glass sheet.
Example 30 includes the IC package of example 29, wherein the buffer material is different from the dielectric material, and the buffer material has a lower modulus of elasticity than the dielectric material.
Example 31 includes the IC package of any one of examples 27-30, wherein the magnetic material extends through a first opening in the first glass sheet and extends through a second opening in the second glass sheet, the magnetic material in the first opening separated from the magnetic material in the second opening by a different material.
Example 32 includes the IC package of any one of examples 27-30, wherein the magnetic material extends continuously from a first surface of the first glass sheet to a second surface of the second glass sheet, the first surface of the first glass sheet faces away from the second glass sheet, the second surface of the second glass sheet faces away from the first glass sheet.
Example 33 includes an apparatus comprising a semiconductor chip, a substrate on which the semiconductor chip is mounted, the substrate including a substrate core defined by a first glass layer and a second glass layer, the first glass layer between the semiconductor chip and the second glass layer, the first glass layer having a different coefficient of thermal expansion (CTE) than the second glass layer, and a magnetic inductor through the first and second glass layers of the substrate core, the magnetic inductor including a solid metal core across a cross-section of the metal core.
Example 34 includes the substrate of example 33, further including a dielectric material between the first glass layer and the second glass layer.
Example 35 includes the substrate of example 34, wherein the dielectric material is a first dielectric material, the substrate further including a second dielectric material between the first glass layer and the second glass layer, the second dielectric material is different than the first dielectric material.
Example 36 includes the substrate of example 35, wherein a first layer of the first dielectric material is adjacent the first glass layer, and a second layer of the first dielectric material is adjacent the second glass layer, the second dielectric material between the first layer of the first dielectric material and the second layer of the first dielectric material.
Example 37 includes the substrate of any one of examples 35 or 36, wherein a first segment of the magnetic inductor is in a first hole in the first glass layer, a second segment of the magnetic inductor is in a second hole in the second glass layer, the first segment of the magnetic inductor is spaced apart from the second segment of the magnetic inductor by the second dielectric material.
Example 38 includes the substrate of example 37, wherein the second dielectric material is in contact with the first segment of the magnetic inductor and the second segment of the magnetic inductor.
Example 39 includes the substrate of any one of examples 37 or 38, further including a first conductive pad at a first end of the first segment of the magnetic inductor, and a second conductive pad at a second end of the segment of the magnetic inductor, the first and second ends of the respective first and second segments of the magnetic inductor facing towards one another, the first conductive pad spaced apart from the second conductive pad, the first conductive pad electrically coupled to the second conductive pad.
Example 40 includes the substrate of any one of examples 34-39, wherein the magnetic inductor includes a magnetic material within a first hole in the first glass layer, and the dielectric material separates the magnetic material from an inner wall of the first hole.
Example 41 includes a substrate for an integrated circuit package, the substrate comprising a first glass layer having a first coefficient of thermal expansion (CTE), a second glass layer having a second CTE, the second CTE different from the first CTE, and a magnetic material lining a first wall of a first opening in the first glass layer and lining a second wall of a second opening in the second glass layer.
Example 42 includes the substrate of example 41, wherein the magnetic material extends continuously from within the first opening of the first glass layer to within the second opening in the second glass layer.
Example 43 includes the substrate of example 41, wherein the magnetic material in the first opening is spaced apart from the magnetic material in the second opening.
Example 44 includes the substrate of any one of examples 41-43, further including a conductive material in the first opening and in the second opening.
Example 45 includes the substrate of example 44, wherein the conductive material defines a first pad at a first end of the magnetic material in the first opening, and a second pad at a second end of the magnetic material in the second opening, the first and second ends of the magnetic material in the respective first and second openings facing towards one another, the first pad spaced apart from and electrically coupled to the second pad.
Example 46 includes the substrate of any one of examples 44 or 45, wherein the conductive material and the magnetic material define a first plated magnetic via (PMV) at least partly through the first glass layer and a second PMV at least partly through the second glass layer, the first PMV electrically coupled to the second PMV.
Example 47 includes the substrate of any one of examples 44-46, further including a metal layer lining the first wall of the first opening, the metal layer different from the conductive material, the magnetic material separating the metal layer from the conductive material.
Example 48 includes the substrate of any one of examples 41-47, further including a dielectric material between the first glass layer and the second glass layer.
Example 49 includes the substrate of example 48, further including a buffer material between the first glass layer and the second glass layer, the buffer material different from the dielectric material.
Example 50 includes the substrate of example 49, wherein the buffer material has a lower modulus of elasticity than the dielectric material.
Example 51 includes the substrate of any one of examples 48-50, wherein the dielectric material extends along the first wall of the first opening to separate the magnetic material from the first wall of the first opening.
Example 52 includes the substrate of any one of examples 41-51, wherein the first and second glass layers are in a stack of glass layers, different ones of the glass layers having different CTEs, the different CTEs in the stack of the glass layers define a symmetric sequence of CTEs from a lowermost glass layer in the stack to an uppermost glass layer in the stack.
Example 53 includes an integrated circuit (IC) package comprising a semiconductor die, a first glass layer having a first coefficient of thermal expansion (CTE), a second glass layer distinct from the first glass layer, the second glass layer having a second CTE, and a build-up region having a third CTE, the build-up region between the semiconductor die and the first glass layer, the first glass layer between the build-up region and the second glass layer, the first CTE closer to the third CTE than the second CTE is to the third CTE, and a power delivery interconnect extending through the first and second glass layers, the power delivery interconnect including a magnetic material.
Example 54 includes the IC package of example 53, further including an adhesive material between the first glass layer and the second glass layer, the adhesive material to abut a first surface of the first glass layer and a second surface of the second glass layer.
Example 55 includes the IC package of example 54, further including a first conductive pad, and a second conductive pad, the adhesive material between the first and second conductive pads.
Example 56 includes the IC package of example 55, further including a conductive via electrically coupling the first and second conductive pads.
Example 57 includes an apparatus comprising a package substrate including a stack of glass layers, adjacent ones of the glass layers having different compositions of materials associated with different coefficients of thermal expansion (CTEs), a semiconductor chip mounted to the package substrate, and a plated magnetic via at least partly through the stack of glass layers, the plated magnetic via including a magnetic material.
Example 58 includes the apparatus of example 57, wherein the glass layers in the stack define a CTE gradient that is symmetrical across the stack.
Example 59 includes the apparatus of any one of examples 57 or 58, further including a dielectric material between the adjacent ones of the glass layers.
Example 60 includes the apparatus of any one of examples 57-59, further including at least one of a keyboard or a display.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. A substrate for an integrated circuit package, the substrate comprising:
a first glass layer having a first coefficient of thermal expansion (CTE);
a second glass layer having a second CTE, the second CTE different from the first CTE;
a conductive material extending at least partly through a first hole in the first glass layer and a second hole in the second glass layer; and
a magnetic material between an inner wall of the first hole and the conductive material.

2. The substrate of claim 1, wherein the conductive material and the magnetic material define a coaxial magnetic inductor loop (CMIL).

3. The substrate of claim 2, further including a non-magnetic plug within the CMIL, the conductive material surrounding the non-magnetic plug, and the magnetic material surrounding the conductive material.

4. The substrate of any one of claims 2-3, wherein the CMIL is a first CMIL, the substrate includes a second CMIL adjacent the first CMIL, and both the first and second CMILs respectively extend through the first and second holes of the respective first and second glass layers.

5. The substrate of any one of claims 1-4, further including a dielectric material between the first glass layer and the second glass layer.

6. The substrate of claim 5, wherein the dielectric material has a lower modulus of elasticity than the first glass layer.

7. The substrate of any one of claims 5-6, wherein the dielectric material includes an organic dielectric.

8. The substrate of claim 7, wherein the dielectric material includes at least one of parylene or polyimide.

9. The substrate of any one of claims 5-6, wherein the dielectric material includes an inorganic dielectric.

10. The substrate of claim 9, wherein the dielectric material includes at least one of silicon, oxygen, or nitrogen.

11. The substrate of any one of claims 1-10, further including a third glass layer having a third CTE, the second glass layer distinct from the first glass layer, the third glass layer distinct from the first glass layer and distinct from the second glass layer.

12. The substrate of claim 11, further including:
a first build-up region having a fifth CTE; and
a second build-up region having a sixth CTE, the first second, and third glass layers between the first and second build-up regions, the first glass layer adjacent the first build-up region, the second glass layer is adjacent the second build-up region, and the third glass layer is between the first glass layer and the second glass layer, the first CTE closer to the fifth CTE than the third CTE is to the fifth CTE, the second CTE closer to the sixth CTE than the third CTE is to the sixth CTE.

13. The substrate of any one of claim 12, further including a fourth glass layer between the first glass layer and the third glass layer, the fourth glass layer having a seventh CTE between the first CTE and the third CTE.

14. The substrate of any one of claims 11-13, wherein the second CTE corresponds to the first CTE, and the first CTE is higher than the third CTE.

15. The substrate of any one of claims 1-14, wherein the magnetic material extends continuously from within the first hole of the first glass layer to within the second hole in the second glass layer.
